# EUROPEAN PATENT APPLICATION

(11) **EP 4 753 418 A1**
(43) Date of publication of application: **03.06.2026**
(21) Application number: 23948060.1
(22) Date of filing: 10.08.2023
(51) Int. Cl.: H10K 59/12, G09G 3/3208

(54) **DISPLAY SUBSTRATE, MANUFACTURING METHOD THEREFOR AND DISPLAY APPARATUS**

(71) Applicant: Boe Technology Group Co., Ltd., Beijing 100015 (CN); Hefei BOE Joint Technology Co., Ltd., Hefei, Anhui 230012 (CN); Beijing BOE Technology Development Co., Ltd., Beijing 100176 (CN)
(72) Inventor: LIU, Xiuting, Beijing 100176 (CN); YUAN, Zhidong, Beijing 100176 (CN); HAN, Ying, Beijing 100176 (CN); LI, Yongqian, Beijing 100176 (CN); ZHANG, Dacheng, Beijing 100176 (CN); ZHOU, Dandan, Beijing 100176 (CN)
(74) Representative: Durán-Corretjer, S.L.P.
(86) International application number: PCT/CN2023/112256
(87) International publication number: WO 2025/030485

(57) **Abstract**

A display substrate, a manufacturing method therefor and a display apparatus. The display substrate comprises a plurality of repetitive units (100), a repetitive unit (100) comprising a plurality of sub-pixels; a sub-pixel at least comprises a pixel driving circuit, the pixel driving circuit being connected to a first power line (51); the pixel driving circuit at least comprises a driving transistor (T2) and a power connection electrode (20), the driving transistor (T2) comprising a driving active layer (22); a first end of the power connection electrode (20) is connected to the first power line (51) by means of a power via hole (K1), and a second end of the power connection electrode (20) is connected to a first region of the driving active layer (22) by means of an active via hole (K2); adjacent sub-pixels in the adjacent repetitive units in a pixel row direction and a pixel column direction share the power via holes (K1).

## Description

### Technical Field

The present disclosure relates to, but is not limited to, the field of display technologies, and in particular to a display substrate, a method for manufacturing the display substrate, and a display apparatus.

### Background

An organic light emitting diode (OLED for short) and a quantum dot light emitting diode (QLED for short) are active light emitting display devices and have advantages such as self-luminescence, wide viewing angle, high contrast ratio, low power consumption, very high response speed, lightness and thinness, flexibility, and low cost. With continuous development of display technologies, a display apparatus in which an OLED or a QLED is used as a light emitting device and a thin film transistor (TFT) is used for signal control has become a mainstream product in the field of display at present.

### Summary

The following is a summary of subject matter described herein in detail. The summary is not intended to limit the scope of protection of the claims.

In one aspect, the present disclosure provides a display substrate including multiple repetition units, at least one repetition unit includes multiple sub-pixels forming at least two pixel rows and at least two pixel columns, at least one sub-pixel includes a pixel drive circuit, the pixel drive circuit is connected to a first power supply line, the first power supply line is configured to provide a first power supply signal to the pixel drive circuit; the pixel drive circuit at least includes a drive transistor and a power supply connection electrode, the drive transistor at least includes a drive active layer; in at least one sub-pixel, a first end of the power supply connection electrode is connected to the first power supply line through a power supply via, and a second end of the power supply connection electrode is connected to a first region of the drive active layer through an active via; two adjacent sub-pixels of two repetition units adjacent in a pixel row direction share the power supply via and two adjacent sub-pixels of two repetition units adjacent in a pixel column direction share the power supply via.

In an exemplary implementation, first regions of drive active layers of two adjacent sub-pixels of two repetition units adjacent in the pixel column direction are connected to each other.

In an exemplary implementation, the drive active layers of the two adjacent sub-pixels in the two repetition units adjacent in the pixel column direction are interconnected to form an integral structure, the drive active layers of the integral structure have grooves, openings of the adjacent grooves in at least one repetition unit are provided oppositely, a groove has a groove width and a groove depth, the groove width is a dimension in the pixel column direction, and the groove depth is a dimension in the pixel row direction.

In an exemplary implementation, first ends of power supply connection electrodes of two adjacent sub-pixels of two repetition units adjacent in the pixel row direction are connected to each other and two adjacent sub-pixels of two repetition units adjacent in the pixel column direction share the power supply connection electrodes.

In an exemplary implementation, the power supply connection electrodes of the two adjacent sub-pixels of the two repetition units adjacent in the pixel row direction are interconnected to form an integral structure.

In an exemplary implementation, the pixel drive circuit further includes an active connection electrode, a first end of the active connection electrode is connected to the first region of the drive active layer, the power supply connection electrode is simultaneously connected to the first power supply line and a second end of the active connection electrode through a switch via, the switch via includes a shallow half hole and a deep half hole, the shallow half hole is an active via exposing the second end of the active connection electrode, and the deep half hole is a power supply via exposing the first power supply line.

In an exemplary implementation, the active connection electrode and the drive active layer are interconnected to form an integral structure.

In an exemplary implementation, two adjacent sub-pixels of two repetition units adjacent in the pixel row direction share a switch via and two adjacent sub-pixels of two repetition units adjacent in the pixel column direction share a switch via.

In an exemplary implementation, adjacent sub-pixels of repetition units adjacent in the pixel row direction and the pixel column direction share the switch via.

In an exemplary implementation, second ends of active connection electrodes of two adjacent sub-pixels of two repetition units adjacent in the pixel row direction are connected to each other and two adjacent sub-pixels of two repetition units adjacent in the pixel column direction share the active connection electrode.

In an exemplary implementation, the active connection electrodes of the two adjacent sub-pixels of the two repetition units adjacent in the pixel row direction are interconnected to form an integral structure.

In an exemplary implementation, first regions of second active layers in adjacent sub-pixels of repetition units adjacent in the pixel row direction and the pixel column direction are connected to each other through the active connection electrodes.

In an exemplary implementation, adjacent sub-pixels of repetition units adjacent in the pixel row direction and the pixel column direction share the power supply connection electrode.

In an exemplary implementation, the power supply connection electrodes of two adjacent sub-pixels of two repetition units adjacent in the pixel row direction are interconnected to form an integral structure and power supply connection electrodes of two adjacent sub-pixels of two repetition units adjacent in the pixel column direction are interconnected to form an integral structure.

In an exemplary implementation, at least one repetition unit includes two first power supply lines, four data signal lines and one compensation signal line, the compensation signal line is between adjacent pixel columns, the two first power supply lines are on two sides of a repetition unit in the pixel row direction, the first one of the first power supply lines, the first data signal line, the second data signal line, the compensation signal line, the third data signal line, the fourth data signal line and the second one of the first power supply lines are sequentially provided along the pixel row direction, and the drive transistor is provided between the second data signal line and the compensation signal line or between the compensation signal line and the third data signal line.

In an exemplary implementation, in at least one sub-pixel, the pixel drive circuit further includes a first connection electrode, a second connection electrode, and a storage capacitor, the storage capacitor at least includes a first plate, the first connection electrode and the second connection electrode are provided on two sides of the first plate in the pixel column direction, and are respectively connected to the first plate; in at least one sub-pixel, a width of the first connection electrode is less than a width of the second connection electrode, and a width is a dimension in the pixel row direction.

In an exemplary implementation, in a direction perpendicular to the display substrate, the display substrate includes a second conductive layer, a semiconductor layer, and a third conductive layer that are sequentially provided on a base substrate, the first power supply line is provided in the second conductive layer, the drive active layer is provided in the semiconductor layer, and the power supply connection electrode is provided in the third conductive layer.

In an exemplary implementation, widths of drive active layers in adjacent sub-pixels in the pixel row direction are different, widths of drive active layers in adjacent sub-pixels in the pixel column direction are different, and a width is a minimum dimension of a drive active layer in the pixel column direction.

In an exemplary implementation, in the pixel row direction, a first sub-pixel and a second sub-pixel are alternately provided, a width of a drive active layer in the first sub-pixel is greater than a width of a drive active layer in the second sub-pixel; or, in the pixel row direction, a third sub-pixel and a fourth sub-pixel are alternately provided, a width of a drive active layer in the third sub-pixel is less than a width of a drive active layer in the fourth sub-pixel.

In an exemplary implementation, in the pixel column direction, a first sub-pixel and a third sub-pixel are alternately provided, a width of a drive active layer in the first sub-pixel is greater than a width of a drive active layer in the third sub-pixel; or, in the pixel column direction, a second sub-pixel and a fourth sub-pixel are alternately provided, a width of a drive active layer in the second sub-pixel is less than a width of a drive active layer in the fourth sub-pixel.

In another aspect, the present disclosure further provides a display apparatus, including the display substrate described above.

In another aspect, the present disclosure further provides a method for manufacturing a display substrate, the display substrate includes multiple repetition units, at least one repetition unit includes multiple sub-pixels forming at least two pixel rows and at least two pixel columns; the manufacturing method includes:
forming a pixel drive circuit in at least one sub-pixel, wherein the pixel drive circuit is connected to a first power supply line, the first power supply line is configured to supply a first power signal to the pixel drive circuit; the pixel drive circuit at least includes a drive transistor and a power supply connection electrode, the drive transistor at least includes a drive active layer; in at least one sub-pixel, a first end of the power supply connection electrode is connected to the first power supply line through a power supply via, and a second end of the power supply connection electrode is connected to a first region of the drive active layer through an active via; two adjacent sub-pixels of two repetition units adjacent in a pixel row direction share a power supply via and two adjacent sub-pixels of two repetition units adjacent in a pixel column direction share a power supply via.

Other aspects may be comprehended upon reading and understanding drawings and detailed description.

### Brief Description of Drawings

Accompanying drawings are intended to provide further understanding of technical solutions of the present disclosure and form a part of the specification, and are used to explain the technical solutions of the present disclosure together with embodiments of the present disclosure, but do not form limitations on the technical solutions of the present disclosure. Shapes and sizes of various components in the drawings do not reflect actual scales, but are only intended to schematically illustrate contents of the present disclosure.
FIG. 1 is a schematic diagram of a structure of a display apparatus.
FIG. 2 is a schematic diagram of a planar structure of a display substrate according to an exemplary embodiment of the present disclosure.
FIG. 3 is an equivalent circuit diagram of a pixel drive circuit in a repetition unit according to an exemplary embodiment of the present disclosure.
FIG. 4 is a schematic diagram of a structure of a display substrate according to an embodiment of the present disclosure.
FIG. 5 is a schematic diagram of a display substrate after a pattern of a first conductive layer is formed according to the present disclosure.
FIG. 6A and FIG. 6B are schematic diagrams of a display substrate after a pattern of a second conductive layer is formed according to the present disclosure.
FIG. 7A and FIG. 7B are schematic diagrams of a display substrate after a pattern of a semiconductor layer is formed according to the present disclosure.
FIG. 8 is a schematic diagram of a display substrate after a pattern of a second insulation layer is formed according to the present disclosure.
FIG. 9A and FIG. 9B are schematic diagrams of a display substrate after a pattern of a third conductive layer is formed according to the present disclosure.
FIG. 9C is a cross-sectional view taken along direction A-A in FIG. 9A.
FIG. 9D to FIG. 9F are cross-sectional views taken along direction B-B in FIG. 9A.
FIG. 10 is a schematic diagram of a display substrate after patterns of a third insulation layer and a planarization layer are formed according to the present disclosure.
FIG. 11A and FIG. 11B are schematic diagrams of a display substrate after a pattern of a fourth conductive layer is formed according to the present disclosure.
FIG. 12 is a schematic diagram of a display substrate after a pattern of a pixel definition layer is formed according to the present disclosure.
FIG. 13 is a schematic diagram of a structure of another display substrate according to an embodiment of the present disclosure.
FIG. 14A and FIG. 14B are schematic diagrams of another display substrate after a pattern of a semiconductor layer is formed according to the present disclosure.
FIG. 15 is a schematic diagram of another display substrate after a pattern of a second insulation layer is formed according to the present disclosure.
FIG. 16A and FIG. 16B are schematic diagrams of another display substrate after a pattern of a third conductive layer is formed according to the present disclosure.
FIG. 17 is a schematic diagram of a structure of another display substrate according to an embodiment of the present disclosure.
FIG. 18A and FIG. 18B are schematic diagrams of another display substrate after a pattern of a semiconductor layer is formed according to the present disclosure.
FIG. 19 is a schematic diagram of another display substrate after a pattern of a second insulation layer is formed according to the present disclosure.
FIG. 20A and FIG. 20B are schematic diagrams of another display substrate after a pattern of a third conductive layer is formed according to the present disclosure.

Reference signs are described as follows.

| | | | | | |
|---|---|---|---|---|---|
| 10- | base substrate; | 11- | first connection electrode; | 12- | second connection electrode; |
| 13- | third connection electrode; | 14- | fourth connection electrode; | 15- | fifth connection electrode; |
| 16- | sixth connection electrode; | 17- | seventh connection electrode; | 18- | eighth connection electrode; |
| 20- | power supply connection electrode; | 21- | first active layer; | 22- | second active layer; |
| 23- | third active layer; | 24- | active connection electrode; | 30- | scan signal line |
| 31- | first gate electrode; | 32- | second gate electrode; | 33- | third gate electrode; |
| 51- | first power supply line; | 52- | data signal line; | 53- | compensation signal line; |
| 60- | storage capacitor; | 61- | first plate; | 62- | second plate; |
| 63- | first electrode; | 64- | anode connection electrode; | 71- | first insulation layer; |
| 72- | second insulation layer; | 81- | first connection block; | 82- | second connection block; |
| 91- | recess; | 92- | groove; | 100- | repetition unit. |

### Detailed Description

To make the objectives, technical solutions, and advantages of the present disclosure clearer, the embodiments of the present disclosure will be described in detail below with reference to the accompany drawings. Implementations may be implemented in multiple different forms. Those of ordinary skills in the art can easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one implementation of the present disclosure is not limited to shapes, numerical values, or the like shown in the drawings.

Ordinal numerals "first", "second", "third", etc., in the specification are set not to form limits in numbers but only to avoid confusion between composition elements.

In the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the composition elements may be changed as appropriate according to a direction according to which each composition element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be fixed connection, or detachable connection, or integral connection; it may be mechanical connection or electrical connection; it may be direct connection, or indirect connection through an intermediate, or internal communication between two elements. Those of ordinary skills in the art can understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In cases that transistors with opposite polarities are used, or a current direction changes during operation of a circuit, or the like, functions of the "source electrode" and the "drain electrode" are sometimes interchangeable. Therefore, the "source electrode" and the "drain electrode", as well as the "source terminal" and the "drain terminal", are interchangeable in the specification.

In the specification, "electrical connection" includes connection of composition elements through an element with a certain electrical action. An "element with a certain electrical action" is not particularly limited as long as electric signals between the connected composition elements may be sent and received. Examples of the "element with the certain electrical action" not only include an electrode and a wire, but also include a switch element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive film" sometimes. Similarly, an "insulation film" may be replaced with an "insulation layer" sometimes.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

In the present disclosure, "about" refers to that a boundary is not defined so strictly and numerical values within a range of process and measurement errors are allowed.

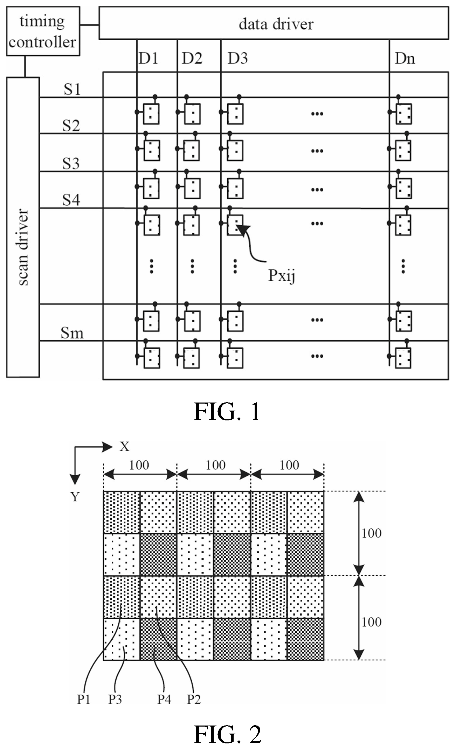

FIG. 1 is a schematic diagram of a structure of a display apparatus. As shown in FIG. 1, an OLED display apparatus may include a timing controller, a data driver, a scan driver, and a pixel array. The timing controller is connected to the data driver and the scan driver respectively. The data driver is connected to multiple data signal lines (D1 to Dn) respectively. The scan signal driver is connected to multiple scan signal lines (S1 to Sm) respectively. The pixel array may include multiple sub-pixels Pxij. Each sub-pixel Pxij may be connected to a corresponding data signal line and a corresponding scan signal line, wherein i and j may be natural numbers. At least one of the sub-pixels Pxij may at least include a circuit unit and a display unit. The circuit unit may at least include a pixel drive circuit, and the pixel drive circuit connected to a scan signal line and a data signal line respectively. The display unit may at least include a light emitting device, and the light emitting device is connected to the pixel drive circuit of the circuit unit. The sub-pixel Pxij may refer to a sub-pixel whose pixel drive circuit is connected to an i-th scan signal line and a j-th data signal line. In an exemplary embodiment, the timing controller may provide a control signal and a gray scale value suitable for the specification of the data driver to the data driver, and may provide a scan start signal, a clock signal suitable for the specification of the scan driver and the like to the scan driver. The data driver may generate data voltages to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines D1 to Dn by taking a pixel row as a unit, wherein n may be a natural number. The scan driver may generate a scan signals to be provided to the scan signal lines S1, S2, S3, ..., and Sm by receiving the clock signal, the scan start signal and the like from the timing controller. For example, the scan driver may sequentially provide a scan signal with an on-level pulse to the scan signal lines S1 to Sm. For example, the scan driver may be constructed in a form of a shift register and generate a scan signal in a manner of sequentially transmitting the scan start signal provided in a form of an on-level pulse to a next-stage circuit under control of the clock signal, wherein m may be a natural number. In an exemplary implementation, the pixel array may be provided on the display substrate.

An exemplary embodiment of the present disclosure provides a display substrate including multiple repetition units. At least one repetition unit includes multiple sub-pixels forming at least two pixel rows and at least two pixel columns. At least one sub-pixel includes a pixel drive circuit, and the pixel drive circuit is connected to a first power supply line. The first power supply line is configured to provide a first power supply signal to the pixel drive circuit. The pixel drive circuit at least includes a drive transistor and a power supply connection electrode, wherein the drive transistor at least includes a drive active layer. In at least one sub-pixel, a first end of the power supply connection electrode is connected to the first power supply line through a power supply via, and a second end of the power supply connection electrode is connected to a first region of the drive active layer through an active via. Two adjacent sub-pixels of two repetition units adjacent in a pixel row direction share the power supply via and two adjacent sub-pixels of two repetition units adjacent in a pixel column direction share the power supply via.

In an exemplary implementation, the first regions of the drive active layers in two adjacent sub-pixels of two repetition units adjacent in the pixel column direction are connected to each other.

In an exemplary implementation, two adjacent sub-pixels of two repetition units adjacent in the pixel column direction share the active via.

In an exemplary implementation, the pixel drive circuit further includes an active connection electrode, a first end of the active connection electrode is connected to the first region of the drive active layer, and the power supply connection electrode is simultaneously connected to the first power supply line and a second end of the active connection electrode through a switch via. The switch via includes a shallow half hole and a deep half hole, the shallow half hole is an active via exposing the second end of the active connection electrode, and the deep half hole is a power supply via exposing the first power supply line.

In an exemplary implementation, two adjacent sub-pixels of two repetition units adjacent in the pixel row direction share the switch via and two adjacent sub-pixels of two repetition units adjacent in the pixel column direction share the switch via.

In an exemplary implementation, first ends of the power supply connection electrodes in two adjacent sub-pixels of two repetition units adjacent in the pixel row direction are connected to each other and first ends of the power supply connection electrodes in two adjacent sub-pixels of two repetition units adjacent in the pixel column direction are connected to each other.

In an exemplary implementation, the power supply connection electrodes in two adjacent sub-pixels of two repetition units adjacent in the pixel row direction are interconnected to form an integral structure and the power supply connection electrodes in two adjacent sub-pixels of two repetition units adjacent in the pixel column direction are interconnected to form an integral structure.

In an exemplary implementation, two adjacent sub-pixels of two repetition units adjacent in the pixel row direction means that one of the two repetition units adjacent in the pixel row direction includes a sub-pixel A and the other of the two repetition units includes a sub-pixel B, and the sub-pixel A and the sub-pixel B are adjacent in the pixel row direction. Two adjacent sub-pixels of two repetition units adjacent in the pixel column direction means that one of the two repetition units adjacent in the pixel column direction includes a sub-pixel C and the other of the two repetition units includes a sub-pixel D, and the sub-pixel C and the sub-pixel D are adjacent in the pixel column direction.

The display substrate of the present disclosure is illustrated with examples below through some exemplary embodiments.

FIG. 2 is a schematic diagram of a planar structure of a display substrate according to an exemplary embodiment of the present disclosure. As shown in FIG. 2, in an exemplary implementation and in a direction parallel to the display substrate, the display substrate may include multiple repetition units 100. At least one repetition unit 100 may include multiple sub-pixels forming at least two pixel rows and at least two pixel columns. In an exemplary implementation, a repetition unit is a basic unit forming the display substrate, and the display substrate is formed by repetition and continuously disposing along at least one direction, i.e., the display substrate is formed by splicing multiple repetition units.

In an exemplary implementation, a repetition unit 100 may include four sub-pixels, the four sub-pixels may include a first sub-pixel P1 that emits a first color light, a second sub-pixel P2 that emits a second color light, a third sub-pixel P3 that emits a third color light, and a fourth sub-pixel P4 that emits a fourth color light. The four sub-pixels may be arranged in a square so that an aperture ratio and a light transmission area can be effectively increased.

In an exemplary implementation, in at least one repetition unit 100, a second sub-pixel P2 may be provided on a side of the first sub-pixel P1 in an extension direction of the first direction X, a third sub-pixel P3 may be provided on a side of the first sub-pixel P1 of in extension direction of the second direction Y, and a fourth sub-pixel P4 may be provided on a side of the third sub-pixel P3 in the extension direction of the first direction X. Multiple sub-pixels provided sequentially along the first direction X may be referred to as a pixel row, multiple sub-pixels provided sequentially along the second direction Y may be referred to as a pixel column, and a pixel array is formed by multiple pixel rows and multiple pixel columns arranged in an array, and the first direction X intersects with the second direction Y.

In an exemplary implementation, the first sub-pixel P1 may be a red sub-pixel (R) emitting red light, the second sub-pixel P2 may be a blue sub-pixel (G) emitting blue light, the third sub-pixel P3 may be a white sub-pixel (W) emitting white light, and the fourth sub-pixel P4 may be a green sub-pixel (B) emitting green light. In some possible implementations, an arrangement of RBWG may be adjusted according to actual needs, which is not specifically limited here in the present disclosure.

In an exemplary implementation, in a direction perpendicular to the display substrate, the display substrate may at least include a drive circuit layer provided on the base substrate and a light emitting structure layer provided on a side of the drive circuit layer away from the base substrate. In at least one repetition unit, the drive circuit layer may include multiple circuit units. A circuit unit may at least include a pixel drive circuit, and the pixel drive circuit is connected to a scan signal line, a data signal line and the like respectively. The pixel drive circuit is configured to receive a data voltage transmitted by the data signal line and output a corresponding current to a light emitting device under control of the scan signal line. The light emitting structure layer may include multiple light emitting units. A light emitting unit may at least include a light emitting device, the light emitting device is connected to a pixel drive circuit of the circuit unit of the sub-pixel where the light emitting device is located, and the light emitting device is configured to emit light of corresponding brightness in response to a current output by the pixel drive circuit of the sub-pixel where the light emitting device is located.

In another exemplary implementation, in a direction perpendicular to the display substrate, the display substrate may at least include a drive circuit layer provided on the base substrate, a color filter structure layer provided on a side of the drive circuit layer away from the base substrate, and a light emitting structure layer provided on a side of the color filter structure layer away from the base substrate. In at least one repetition unit, the color filter structure layer may include multiple color filter units. A color filter unit may at least include a color filter layer, and the color filter layer is configured to enable a corresponding sub-pixel to emit light of a desired color.

In an exemplary implementation, the circuit units mentioned in the present disclosure refers to regions divided according to pixel drive circuits. The color filter units mentioned in the present disclosure refers to regions divided according to the color filter layer. The light emitting units mentioned in the present disclosure refers to regions divided according to light emitting devices. A position of an orthographic projection of a circuit unit on the base substrate, a position of an orthographic projection of a color filter layer on the base substrate, and a position of an orthographic projection of a light emitting unit on the base substrate may or may not correspond to each other.

In an exemplary embodiment of the present disclosure, a position of an orthographic projection of a circuit unit on the base substrate, a position of an orthographic projection of a color filter layer on the base substrate, and a position of an orthographic projection of a light emitting unit on the base substrate are substantially corresponding to each other. A sub-pixel is formed by a circuit unit, a color filter unit, and a light emitting unit. Therefore, in the following contents, a sub-pixel is uniformly used to refer to a circuit unit, a color filter unit, and a light emitting unit.

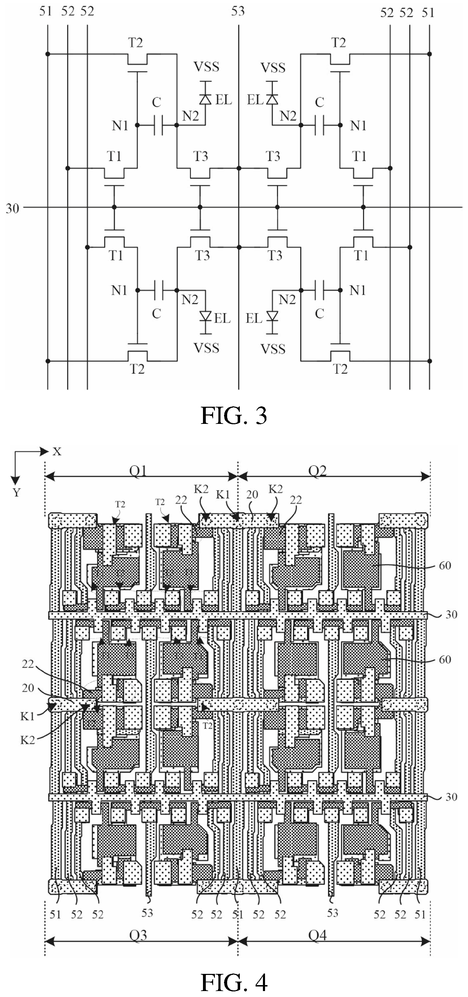

FIG. 3 is an equivalent circuit diagram of a pixel drive circuit in a repetition unit according to an exemplary embodiment of the present disclosure. As shown in FIG. 3, at least one repetition unit may include four pixel drive circuits, the four pixel drive circuits may be arranged in a square, and the pixel drive circuits may be of a 3T1C structure.

In an exemplary implementation, at least one pixel drive circuit may include three transistors (a first transistor T1, a second transistor T2, and a third transistor T3) and one storage capacitor C, and the at least one pixel drive circuit is connected to the scan signal line 30, the first power supply line 51, the data signal line 52, and the compensation signal line 53 respectively.

In an exemplary implementation, each pixel drive circuit may include a first node N1 and a second node N2. The first node N1 is connected to a second electrode of the first transistor T1, a gate electrode of the second transistor T2, and a first end of the storage capacitor C respectively. The second node N2 is connected to a second electrode of the second transistor T2, a second electrode of the third transistor T3, and a second end of the storage capacitor C respectively.

In an exemplary implementation, the first end of the storage capacitor C is connected to the first node N1, the second end of the storage capacitor C is connected to the second node N2, and the storage capacitor C is configured to store a potential of the gate electrode of the second transistor T2.

In an exemplary implementation, the first transistor T1 is a switch transistor, the second transistor T2 is a drive transistor, and the third transistor T3 is a compensation transistor.

In an exemplary implementation, the gate electrode of the first transistor T1 is connected to the scan signal line 30, a electrode of the first transistor T1 is connected to the data signal line 52, and the second electrode of the first transistor T1 is connected to the first node N1. When a turned-on signal is applied to the scan signal line 30, the first transistor T1 inputs a data signal of the data signal line 52 to the gate electrode of the second transistor T2.

In an exemplary implementation, the gate electrode of the second transistor T2 is connected to the first node N1, a first electrode of the second transistor T2 is connected to the first power supply line 51, and the second electrode of the second transistor T2 is connected to the second node N2. The second transistor T2 generates a corresponding current at the second electrode of the second transistor T2 under control of the data signal received by the gate electrode of the second transistor T2.

In an exemplary implementation, a gate electrode of the third transistor T3 is connected to the scan signal line 30, a first electrode of the third transistor T3 is connected to the compensation signal line 53, and a second electrode of the third transistor T3 is connected to the second node N2. When a turned-on signal is applied to the scan signal line 30, the third transistor T3 extracts a threshold voltage Vth and a mobility of the second transistor T2 in response to the compensation timing to compensate the threshold voltage Vth.

In an exemplary implementation, in the pixel drive circuit of the at least one sub-pixel, the gate electrode of the first transistor T1 and the gate electrode of the third transistor T3 are connected to the same scan signal line 30.

In an exemplary implementation, in multiple pixel drive circuits of at least one pixel row, gate electrodes of multiple first transistors T1 and gate electrodes of multiple third transistors T3 are connected to the same scan signal line 30.

In an exemplary implementation, in multiple pixel drive circuits of at least one repetition unit, gate electrodes of multiple first transistors T1 and gate electrodes of multiple third transistors T3 are connected to the same scan signal line 30.

In an exemplary implementation, the light emitting device EL may be an OLED which includes a first electrode, an organic emitting layer, and a second electrode that are stacked, or may be a QLED which includes a first electrode, a quantum dot emitting layer, and a second electrode that are stacked. The first electrode of the light emitting device EL is connected to the second node N2, the second electrode of the light emitting device EL is connected to a second power supply line VSS, and the light emitting device EL emits light of corresponding brightness in response to a current of the second electrode of the second transistor T2. In an exemplary implementation, the first electrode may be an anode and the second electrode may be a cathode. Optionally, the first electrode may be a cathode and the second electrode may be an anode.

In an exemplary implementation, a signal of the first power supply line 51 is a high-level signal continuously provided, and a signal of the second power supply line VSS is a low-level signal continuously provided.

In an exemplary implementation, the first transistor T1 to the third transistor T3 may be P-type transistors, or may be N-type transistors. Use of a same type of transistors in a pixel drive circuit may simplify a process flow, reduce a process difficulty of a display panel, and improve a product yield. In some possible implementations, the first transistor T1 to the third transistor T3 may include a P-type transistor and an N-type transistor.

In an exemplary implementation, for the first transistor T1 to the third transistors T3, low temperature poly-crystalline silicon thin film transistors may be used, oxide thin film transistors may be used, or low temperature poly-crystalline silicon thin film transistors and oxide thin film transistors may be used. An active layer of a low temperature poly-crystalline silicon thin film transistor may be made of low temperature poly-crystalline silicon (LTPS for short), and an active layer of an oxide thin film transistor may be made of an oxide semiconductor (Oxide). The low temperature poly-crystalline silicon thin film transistor has advantages such as, high mobility, fast charging, and the oxide thin film transistor has advantages such a low drain current. The low temperature poly-crystalline silicon thin film transistor and the oxide thin film transistor are integrated on one display substrate to form a LTPS+Oxide (LTPO for short) display substrate, so that advantages of the low temperature poly-crystalline silicon thin film transistor and the oxide thin film transistor can be utilized, low-frequency driving can be achieved, power consumption can be reduced, and display quality can be improved.

FIG. 4 is a schematic diagram of a structure of a display substrate according to an embodiment of the present disclosure, illustrating a structure of four repetition units (sixteen sub-pixels) in a bottom emission display substrate. In an exemplary implementation, the four repetition units may include a first repetition unit Q1, a second repetition unit Q2, a third repetition unit Q3, and a fourth repetition unit Q4. The second repetition unit Q2 may be provided on a side of the first repetition unit Q1 in an extension direction of the first direction X, the third repetition unit Q3 may be provided on a side of the first repetition unit Q1 in an extension direction of the second direction Y, and the fourth repetition unit Q4 may be provided on a side of the third repetition unit Q3 in the extension direction of the first direction X. At least one repetition unit may include four sub-pixels forming two pixel rows and two pixel columns, and the four sub-pixels may include a first sub-pixel P1, a second sub-pixel P2, a third sub-pixel P3 and a fourth sub-pixel P4. The second sub-pixel P2 may be provided on a side of the first sub-pixel P1 in the extension direction of the first direction X, the third sub-pixel P3 may be provided on a side of the first sub-pixel P1 in the extension direction of the second direction Y, and the fourth sub-pixel P4 may be provided on a side of the third sub-pixel P3 in the extension direction of the first direction X. The first direction X intersects with the second direction Y. Multiple sub-pixels provided sequentially along the first direction X may be referred to as a pixel row, multiple sub-pixels provided sequentially along the second direction Y may be referred to as a pixel column, and a pixel array is formed by multiple pixel rows and multiple pixel columns arranged in an array.

In an exemplary implementation, at least one repetition unit may include one scan signal line 30, two first power supply lines 51, four data signal lines 52, and one compensation signal line 53, the aforementioned signal lines are respectively connected to a pixel drive circuit in a corresponding sub-pixel. The scan signal line 30 is configured to provide a scan signal to the pixel drive circuit, the first power supply lines 51 are configured to provide a first power supply signal to the pixel drive circuit, the data signal lines 52 are configured to provide a data signal to the pixel drive circuit, and the compensation signal line 53 is configured to provide a compensation signal to the pixel drive circuit.

In an exemplary implementation, the scan signal line 30 may have a shape of a line with a main body portion extending along the first direction X (the pixel row direction) and the first power supply lines 51, the data signal lines 52, and the compensation signal line 53 may each have a shape of a line with a main body portion extending along the second direction (the pixel column direction). In an exemplary implementation, the scan signal line 30 may be provided between adjacent pixel rows, for example may be provided in the middle of the second direction Y of a repetition unit. The one compensation signal line 53 may be between adjacent pixel columns, for example may be provided in the middle of the first direction X of a repetition unit. The two first power supply lines 51 may be on two sides of a repetition unit in the first direction X. The four data signal lines 52 and the compensation signal line 53 may be between two adjacent first power supply lines 51. Two data signal lines 52 of the four data signal lines 52 may be on a side of one of the first power supply lines 51 close to the compensation signal line 53, the other two data signal lines 52 of the four data signal lines 52 may be on a side of the other first power supply line 51 close to the compensation signal line 53, and the storage capacitor 60 may be between a data signal line 52 and the compensation signal line 53. Thus, the scan signal line 30 extending along the first direction X defines two pixel rows and the compensation signal line 53 extending along the second direction Y may define two pixel columns, which forms a first sub-pixel P1, a second sub-pixel P2, a third sub-pixel P3, and a fourth sub-pixel P4 of a repetition unit.

In an exemplary implementation, each sub-pixel includes a pixel drive circuit. The pixel drive circuit may include a first transistor T1, a second transistor T2, a third transistor T3, and a storage capacitor 60. Each transistor may include a gate electrode, an active layer, a first electrode, and a second electrode, and the storage capacitor 60 may include a first plate and a second plate.

In an exemplary implementation, a first electrode of the first transistor T1 is connected to a data signal line 52, a second electrode of the first transistor T1 is connected to the gate electrode of the second transistor T2 and the second plate of the storage capacitor 60 respectively. A first electrode of the second transistor T2 is connected to a first power supply line 51, a first electrode of the third transistor T3 is connected to the compensation signal line 53, and a second electrode of the third transistor T3 is connected to a second electrode of the second transistor T2 and the first plate of the storage capacitor 60 respectively.

In an exemplary implementation, the pixel drive circuit further includes a power supply connection electrode 20. The second transistor T2 which serves as a drive transistor includes at least a second active layer 22 serving as a drive active layer, and in at least one sub-pixel, a first power supply line 51 is connected to a first region of the second active layer 22 through the power supply connection electrode 20.

In an exemplary implementation, the power supply connection electrode 20 may have a shape of a strip extending along the first direction X, and in at least one sub-pixel, a first end of the power supply connection electrode 20 is connected to the first power supply line 51 through a power supply via K1, and a second end of the power supply connection electrode 20 is connected to a first region of the second active layer 22 through an active via K2.

In an exemplary implementation, two adjacent sub-pixels of two repetition units adjacent in the first direction X (the pixel row direction) share the same power supply via K1 and two adjacent sub-pixels of two repetition units adjacent in the second direction Y (the pixel column direction) share the same power supply via K1.

In an exemplary implementation, two adjacent sub-pixels of two repetition units adjacent in the first direction X refer to that in a first repetition unit Q1 and a second repetition unit Q2 adjacent in the first direction X, the first repetition unit Q1 includes a fourth sub-pixel, the second repetition unit Q2 includes a third sub-pixel, and the fourth sub-pixel of the first repetition unit Q1 and the third sub-pixel of the second repetition unit Q2 are adjacent in the first direction X. Two adjacent sub-pixels of two repetition units adjacent in the second direction Y refer to that in a first repetition unit Q1 and a third repetition unit Q3 adjacent in the second direction Y, the first repetition unit Q1 includes a fourth sub-pixel, the third repetition unit Q3 includes a second sub-pixel, and the fourth sub-pixel of the first repetition unit Q1 and the second sub-pixel of the third repetition unit Q3 are adjacent in the second direction Y.

In an exemplary implementation, adjacent sub-pixels of repetition units adjacent in the first direction X and the second direction Y share the same power supply via K1.

In an exemplary implementation, for a first repetition unit Q1 and a second repetition unit Q2 adjacent in the first direction X, a fourth sub-pixel P4 of the first repetition unit Q1 and a third sub-pixel P3 of the second repetition unit Q2 are two adjacent sub-pixels. For a third repetition unit Q3 and a fourth repetition unit Q4 adjacent in the first direction X, a second sub-pixel P2 of the third repetition unit Q3 and a first sub-pixel P1 of the fourth repetition unit Q4 are two adjacent sub-pixels. For the first repetition unit Q1 and the fourth repetition unit Q4 adjacent in the second direction Y, the fourth sub-pixel P4 of the first repetition unit Q1 and the second sub-pixel P2 of the third repetition unit Q3 are two adjacent sub-pixels. For a second repetition unit Q2 and a fourth repetition unit Q4 adjacent in the second direction Y, the third sub-pixel P3 of the second repetition unit Q2 and the first sub-pixel P1 of the fourth repetition unit Q4 are two adjacent sub-pixels. Therefore, the fourth sub-pixel P4 of the first repetition unit Q1, the third sub-pixel P3 of the second repetition unit Q2, the second sub-pixel P2 of the third repetition unit Q3, and the first sub-pixel P1 of the fourth repetition unit Q4 are adjacent sub-pixels of the repetition units adjacent in the first direction X and the second direction Y, and the aforementioned sub-pixels share the same power supply via K1.

In an exemplary implementation, first regions of second active layers 22 in two adjacent sub-pixels of two repetition units adjacent in the second direction Y are connected to each other, for example, for a first repetition unit Q1 and a third repetition unit Q3 adjacent in the second direction Y, the first regions of the two second active layers 22 in the third sub-pixel P3 of the first repetition unit Q1 and the first sub-pixel P1 of the third repetition unit Q3 are connected to each other, and the first regions of the two second active layers 22 in the fourth sub-pixel P4 of the first repetition unit Q1 and the second sub-pixel P2 of the third repetition unit Q3 are connected to each other. For another example, for a second repetition unit Q2 and a fourth repetition unit Q4 adjacent in the second direction Y, the first regions of the two second active layers 22 in the third sub-pixel P3 of the second repetition unit Q2 and the first sub-pixel P1 of the fourth repetition unit Q4 are connected to each other, and the first regions of the two second active layers 22 in the fourth sub-pixel P4 of the second repetition unit Q2 and the second sub-pixel P2 of the fourth repetition unit Q4 are connected to each other.

In an exemplary implementation, second active layers 22 in two adjacent sub-pixels of two repetition units adjacent in the second direction Y are interconnected to form an integral structure.

In an exemplary implementation, two adjacent sub-pixels of two repetition units adjacent in the second direction Y share the same active via K2. For example, the third sub-pixel P3 of the first repetition unit Q1 and the first sub-pixel P1 of the third repetition unit Q3 share the same active via K2. For another example, the fourth sub-pixel P4 of the first repetition unit Q1 and the second sub-pixel P2 of the third repetition unit Q2 share the same active via K2.

In an exemplary implementation, first ends of the power supply connection electrodes 20 in two adjacent sub-pixels of two repetition units adjacent in the first direction X are connected to each other. For example, first ends of the two power supply connection electrodes 20 in the second sub-pixel P2 of the first repetition unit Q1 and the first sub-pixel P1 of the second repetition unit Q2 are connected to each other. For another example, first ends of the two power supply connection electrodes 20 in the fourth sub-pixel P4 of the first repetition unit Q1 and the third sub-pixel P3 of the second repetition unit Q2 are connected to each other.

In an exemplary implementation, power supply connection electrodes 20 in two adjacent sub-pixels of two repetition units adjacent in the first direction X are interconnected to form an integral structure.

In an exemplary implementation, two adjacent sub-pixels of two repetition units adjacent in the second direction Y share the same power supply connection electrode 20. For example, the third sub-pixel P3 of the first repetition unit Q1 and the first sub-pixel P1 of the third repetition unit Q3 share the same power supply connection electrode 20. For another example, the fourth sub-pixel P4 of the first repetition unit Q1 and the second sub-pixel P2 of the third repetition unit Q2 share the same power supply connection electrode 20.

In an exemplary implementation, widths of the second active layers 22 in sub-pixels adjacent in the first direction X are different, widths of the second active layer 22 in sub-pixels adjacent in the second direction Y are different, and a width may be a minimum dimension of the second active layer 22 in the second direction Y.

In an exemplary implementation, and in the first direction X, a first sub-pixel P1 and a second sub-pixel P2 are alternately provided and a width of the second active layer 22 in the first sub-pixel P1 is greater than a width of the second active layer 22 in the second sub-pixel P2. Optionally, in the first direction X, a third sub-pixel P3 and a fourth sub-pixel P4 are alternately provided and a width of the second active layer 22 in the third sub-pixel P3 is less than a width of the second active layer 22 in the fourth sub-pixel P4.

In an exemplary implementation, in the second direction Y, a first sub-pixel P1 and a third sub-pixel P3 are alternately provided and a width of the second active layer 22 in the first sub-pixel P1 is greater than a width of the second active layer 22 in the third sub-pixel P3. Optionally, in the second direction Y, a second sub-pixel P2 and a fourth sub-pixel P4 are alternately provided and a width of the second active layer 22 in the second sub-pixel P2 is less than a width of the second active layer 22 in the fourth sub-pixel P4.

In an exemplary implementation, in a direction perpendicular to the display substrate, the display substrate may include a first conductive layer, a second conductive layer, a semiconductor layer, and a third conductive layer that are sequentially provided on the base substrate. The first plate of the storage capacitor 60 may be provided in the first conductive layer. The first power supply lines 51, the data signal lines 52, and the compensation signal line 53 may be provided in the second conductive layer. The second plate of the storage capacitor 60 and the second active layer 22 may be provided in the semiconductor layer. The power supply connection electrode 20 and the scan signal line 30 may be provided in the third conductive layer.

Exemplary description is made below through a manufacturing process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed by a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are disposed in a same layer" in the present disclosure means that A and B are formed simultaneously through a same patterning process, and a "thickness" of a film layer is a dimension of the film layer in a direction perpendicular to a display substrate. In an exemplary implementation of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In an exemplary implementation, taking four repetition units (first repetition unit Q1, second repetition unit Q2, third repetition unit Q3, and fourth repetition unit Q4) as an example, the manufacturing process of the display substrate of this embodiment may include the following operations.

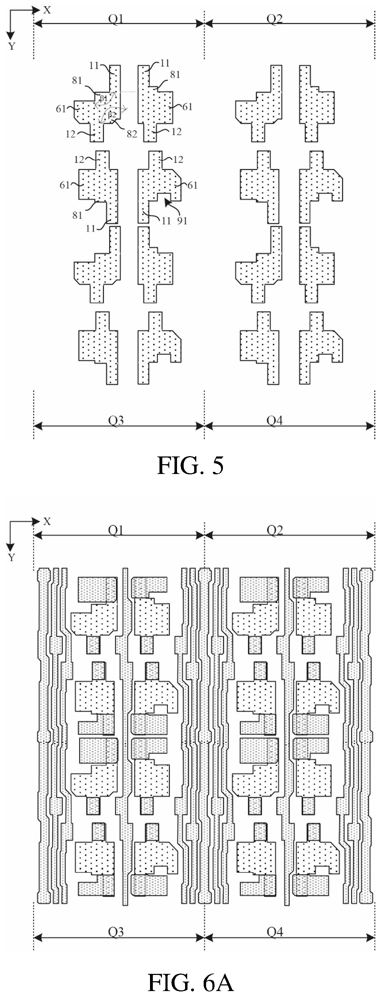

(11) A pattern of a first conductive layer is formed. In an exemplary implementation, forming the pattern of the first conductive layer includes depositing a first conductive thin film on a base substrate, patterning the first conductive thin film by a patterning process to forming the pattern of the first conductive layer on the base substrate, as shown in FIG. 5.

In an exemplary implementation, the first conductive layer of each sub-pixel in each repetition unit may at least include a first connection electrode 11, a second connection electrode 12, and a first plate 61 of a storage capacitor.

In an exemplary implementation, the first plate 61 may have a shape of a rectangle, corners of the rectangle may be chamfered, the first plate 61 may serve as a transparent plate of a transparent storage capacitor, and the first plate 61 is configured to form a transparent storage capacitor with a second plate to be formed subsequently.

In an exemplary implementation, the first connection electrode 11 and the second connection electrode 12 may be on two sides of the first plate 61 in the second direction Y respectively.

In an exemplary implementation, in the first sub-pixel P1 and the second sub-pixel P2, the first connection electrode 11 may be provided on a side of the first plate 61 in an opposite direction of an extension direction of the second direction Y, and the second connection electrode 12 may be provided on a side of the first plate 61 in the extension direction of the second direction Y. In the third sub-pixel P3 and the fourth sub-pixel P4, the first connection electrode 11 may be provided on a side of the first plate 61 in the extension direction of the second direction Y, and the second connection electrode 12 may be provided on a side of the first plate 61 in the opposite direction of the extension direction of the second direction Y.

In an exemplary implementation, the first connection electrode 11 may have a shape of a strip with a main body portion extending along the second direction Y, a first end of the first connection electrode 11 is connected to the first plate 61, a second end of the first connection electrode 11 extends in a direction away from the second connection electrode 12, and the first connection electrode 11 is configured to be connected to a third connection electrode to be formed subsequently.

In an exemplary implementation, the second connection electrode 12 may have a shape of a strip with a main body portion extending along the second direction Y, a first end of the second connection electrode 12 is connected to the first plate 61, a second end of the second connection electrode 12 extends in a direction away from the first connection electrode 11, and the second connection electrode 12 is configured to be connected to a fourth connection electrode to be formed subsequently.

In an exemplary implementation, in a first pixel column, an edge of the first connection electrode 11 close to a second pixel column and an edge of the first plate 61 close to the second pixel column may be substantially flush. In the second pixel column, an edge of the first connection electrode 11 close to the first pixel column and an edge of the first plate 61 close to the first pixel column may be substantially flush.

In an exemplary implementation, the first connection electrode 11, the second connection electrode 12, and the first plate 61 of each sub-pixel may be interconnected to form an integral structure.

In an exemplary implementation, in at least one sub-pixel, a width of the first connection electrode 11 may be less than a width of the second connection electrode 12 and the width may be a dimension in the first direction X.

In an exemplary implementation, in at least one sub-pixel, the pattern of first conductive layer may further include a first connection block 81. The first connection block 81 may have a shape of a block (for example, a rectangle), the first connection block 81 may be provided at a corner where the first connection electrode 11 is connected to the first plate 61, and two adjacent sides of the first connection block 81 are connected to the first connection electrode 11 and the first plate 61 respectively to form a first corner structure. For example, the first sub-pixel may include the first connection block 81. For another example, the second sub-pixel may include the first connection block 81. In yet another example, the third sub-pixel may include the first connection block 81.

In an exemplary implementation, in at least one sub-pixel, the first corner structure may have a first convex corner β1, and the first convex corner β1 may be a right corner.

In an exemplary implementation, in at least one sub-pixel, the pattern of the first conductive layer may further include a second connection block 82. The second connection block 82 may have a shape of a block and may be provided at a corner where the second connection electrode 12 is connected to the first plate 61, and two adjacent sides of the second connection block 82 are connected to the second connection electrode 12 and the first plate 61 respectively to form a second corner structure. For example, the first sub-pixel may include the second connection block 82.

In an exemplary implementation, the second corner structure may have a second convex corner β2 and the second convex corner β2 may be an obtuse corner.

In an exemplary implementation, in at least one sub-pixel, the first plate 61 may be provided with a recess 91. The recess may have a shape of a block (for example, a rectangle), may be provided on a side of the first plate 61 away from the second connection electrode 12, and the recess 91 may have a recess width and a recess depth. The recess width may be greater than the recess depth, the recess width may be a dimension in the first direction X, and the recess depth may be a dimension in the second direction Y.

In an exemplary implementation, in at least one repetition unit, positions of the respective patterns in the first conductive layer in the first sub-pixel P1 and positions of the respective patterns in the first conductive layer in the third sub-pixel P3 may be substantially mirror-symmetrical with respect to a horizontal reference line. Positions of the respective patterns in the first conductive layer in the second sub-pixel P2 and positions of the respective patterns in the first conductive layer in the fourth sub-pixel P4 may be substantially mirror-symmetrical with respect to the horizontal reference line. Positions of the respective patterns in the first conductive layer in the first sub-pixel P1 and positions of the respective patterns in the first conductive layer in the second sub-pixel P2 may be substantially mirror-symmetrical with respect to a vertical reference line. Positions of the respective patterns in the first conductive layer in the third sub-pixel P3 and positions of the respective patterns in the first conductive layer in the fourth sub-pixel P4 may be substantially mirror-symmetrical with respect to the vertical reference line. The horizontal reference line may be a straight line extending along the first direction X and bisecting the repetition units in the second direction Y, and the vertical reference line may be a straight line extending along the second direction Y and bisecting the repetition units in the first direction X.

In some exemplary implementation, the first conductive layer may be made of a transparent conductive material, such as Indium Tin Oxide (ITO) and Indium Zinc Oxide (IZO).

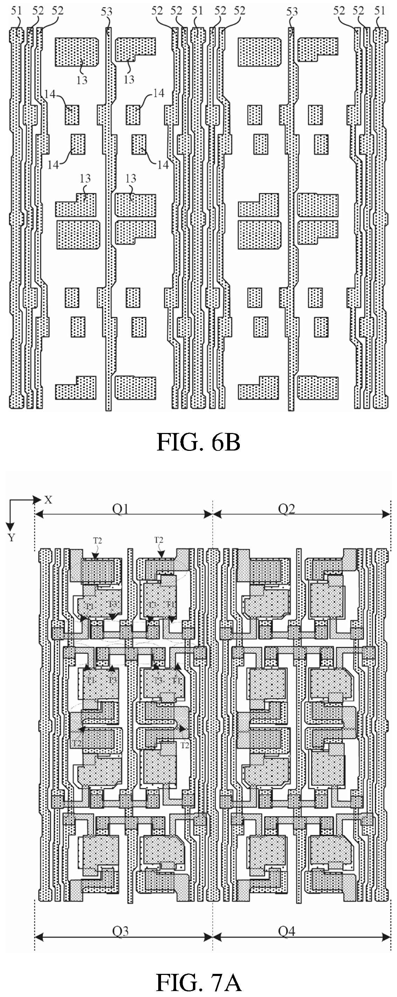

(12) A pattern of a second conductive layer is formed. In an exemplary implementation, forming the pattern of the second conductive layer may include depositing a second conductive thin film on the base substrate on which the aforementioned patterns are formed, and patterning the second conductive thin film by a patterning process to form the second conductive layer, as shown in FIG. 6A and FIG. 6B, and FIG. 6B is a schematic diagram of the second conductive layer in FIG. 6A. In an exemplary implementation, the second conductive layer may be referred to as a shield layer.

In an exemplary implementation, the second conductive layer of each sub-pixel in each repetition unit may at least include a third connection electrode 13 and a fourth connection electrode 14.

In an exemplary implementation, the third connection electrode 13 may have a shape of a block (for example, a rectangle), and may be located on the side of the first plate 61 away from the second connection electrode 12. An orthographic projection of the third connection electrode 13 on the base substrate is at least partially overlapped with an orthographic projection of the first connection electrode 11 on the base substrate, and the third connection electrode 13 is directly overlapped with the first connection electrode 11. In an exemplary implementation, on one hand, the third connection electrode 13 is configured to be connected to a fifth connection electrode to be formed subsequently, and is configured to shield the second transistor on the other hand, so as to reduce an intensity of light irradiated on the second transistor, reduce a leakage current of the second transistor, thereby reducing influence of illumination on characteristics of the second transistor.

In an exemplary implementation, the fourth connection electrode 14 may have a shape of a block (for example, a rectangle), and may be located on a side of the first plate 61 away from the first connection electrode 11. An orthographic projection of the fourth connection electrode 14 on the base substrate is at least partially overlapped with an orthographic projection of the second connection electrode 12 on the base substrate, and the fourth connection electrode 14 is directly overlapped with the second connection electrode 12, and the fourth connection electrode 14 is configured to be connected to a sixth connection electrode to be formed subsequently.

In an exemplary implementation, in at least one sub-pixel, an area of the orthographic projection of the third connection electrode 13 on the base substrate may be greater than an area of the orthographic projection of the fourth connection electrode 14 on the base substrate;

In an exemplary implementation, in at least one repetition unit, an area of an orthographic projection of the third connection electrode 13 in the first sub-pixel on the base substrate may be greater than an area of an orthographic projection of the third connection electrode 13 in another sub-pixel on the base substrate.

In an exemplary implementation, in at least one repetition unit, an area of an orthographic projection of the fourth connection electrode 14 in each sub-pixel on the base substrate may be substantially the same.

In an exemplary implementation, the second conductive layer of each repetition unit in the display substrate may at least include two first power supply lines 51, four data signal lines 52, and one compensation signal line 53.

In an exemplary implementation, the first power supply lines 51, the data signal lines 52, and the compensation signal line 53 may each have a shape of a straight line or a polygonal line with a main body portion extending along the second direction Y. The compensation signal line 53 may be between adjacent sub-pixel columns of the repetition units, for example, in the middle of the first direction X of a repetition unit. A first one of the first power supply lines 51 may be on a side of the repetition unit in an opposite direction of an extension direction of the first direction X, and a second one of the first power supply lines 51 may be on a side of the repetition unit in the extension direction of the first direction X. Two data signal lines 52 of the four data signal lines 52 may be between the first one of the first power supply lines 51 and the compensation signal line 53, and the other two data signal lines 52 of the four data signal lines 52 may be between the second one of the first power supply lines 51 and the compensation signal line 53.

In an exemplary implementation, the first one of the first power supply lines 51 and the compensation signal line 53 may define a first pixel column, and the two data signal lines 52 are provided in the first pixel column. The second one of the first power supply lines 51 and the compensation signal line 53 may define a second pixel column, and the two data signal lines 52 are provided in the second pixel column.

In an exemplary implementation, the four data signal lines 52 may include a first data signal line and a second data signal line provided in the first pixel column, and a third data signal line and a fourth data signal line provided in the second pixel column. The first one of the first power supply lines, the first data signal line, the second data signal line, the compensation signal line, the third data signal line, the fourth data signal line, and the second one of the first power supply lines are sequentially provided along the extension direction of the first direction X. The first plate 61 may be between the second data signal line and the compensation signal line 53 or between the compensation signal line 53 and the third data signal line.

In an exemplary implementation, in at least one repetition unit, positions of the two first power supply lines 51 may be substantially mirror-symmetrical with respect to the vertical reference line, and positions of the two data signal lines 52 on a side of the compensation signal line 53 in the opposite direction of the first direction X and positions of the two data signal lines 52 on a side of the compensation signal line 53 in the first direction X may be substantially mirror-symmetrical with respect to the vertical reference line.

In an exemplary implementation, in at least one repetition unit, positions of the third connection electrode 13 and the fourth connection electrode 14 in the first sub-pixel P1 and positions of the third connection electrode 13 and the fourth connection electrode 14 in the second sub-pixel P2 are substantially mirror-symmetrical with respect to the vertical reference line. Positions of the third connection electrode 13 and the fourth connection electrode 14 in the third sub-pixel P3 and positions of the third connection electrode 13 and the fourth connection electrode 14 in the fourth sub-pixel P4 are substantially mirror-symmetrical with respect to the vertical reference line. Positions of the third connection electrode 13 and the fourth connection electrode 14 in the first sub-pixel P1 and positions of the third connection electrode 13 and the fourth connection electrode 14 in third sub-pixel P3 may be substantially mirror-symmetrical with respect to the horizontal reference line. Positions of the third connection electrode 13 and the fourth connection electrode 14 in the second sub-pixel P2 and positions of the third connection electrode 13 and the fourth connection electrode 14 in fourth sub-pixel P4 may be substantially mirror-symmetrical with respect to the horizontal reference line.

In an exemplary implementation, two repetition units adjacent in the first direction X may share a same first power supply line 51. For example, the first repetition unit Q1 and the second repetition unit Q2 may share a same first power supply line 51. For another example, the third repetition unit Q3 and the fourth repetition unit Q4 may share a same first power supply line 51. The present disclosure can effectively reduce a quantity of signal lines and a quantity of vias, reduce an area occupied by the pixel drive circuits, increase a pixel aperture ratio and improve a display resolution by providing the adjacent repetition units to share the same first power supply line.

In an exemplary implementation, the first power supply lines 51, the data signal lines 52, and the compensation signal line 53 may be polygonal lines with non-equal widths, and adopting polygonal lines with variable widths may not only facilitate a layout of the pixel structure, but also reduce a parasitic capacitance.

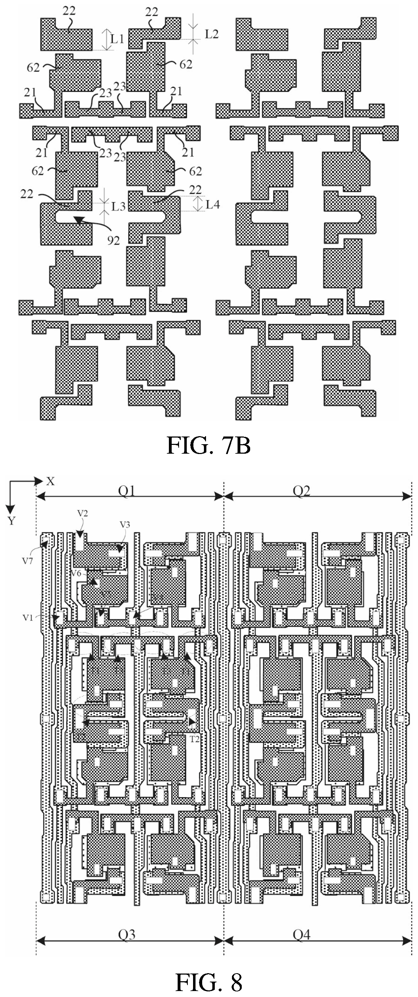

(13) A pattern of a semiconductor layer is formed. In an exemplary implementation, forming the pattern of the semiconductor layer may include depositing a first insulation thin film and a semiconductor thin film sequentially on the base substrate on which the aforementioned patterns are formed, and patterning the semiconductor thin film by a patterning process to form a first insulation layer that covers the first conductive layer and the second conductive layer and the semiconductor layer provided on the first insulation layer, as shown in FIG. 7A and FIG. 7B, and FIG. 7B is a schematic diagram of the semiconductor layer in FIG. 7A.

In an exemplary implementation, the semiconductor layer of each sub-pixel in each repetition unit may at least include a first active layer 21, a second active layer 22, a third active layer 23, and a second plate 62 of a storage capacitor. The first active layer 21 may serve as an active layer of the first transistor T1, the second active layer 22 may serve as an active layer of the second transistor T2, the third active layer 23 may serve as an active layer of the third transistor T3, the second plate 62 may serve as another transparent plate of the transparent storage capacitor, and the second plate 62 is configured to form the transparent storage capacitor with the first plate 61.

In an exemplary implementation, for the first sub-pixel P1 and the second sub-pixel P2, the first active layer 21 and the third active layer 23 may be provided on a side of the first plate 61 of the current sub-pixel in the extension direction of the second direction Y, and the second active layer 22 may be provided on a side of the first plate 61 of the current sub-pixel in the opposite direction of the extension direction of the second direction Y.

In an exemplary implementation, for the first sub-pixel P1, the first active layer 21 may be provided on a side of the corresponding sub-pixel away from the second sub-pixel P2, and the third active layer 23 may be provided on a side of the first sub-pixel P1 close to the second sub-pixel P2. For the second sub-pixel P2, the first active layer 21 may be provided on a side of the second sub-pixel P2 away from the first sub-pixel P1, and the third active layer 23 may be provided on a side of the second sub-pixel P2 close to the first sub-pixel P1.

In an exemplary implementation, for the third sub-pixel P3 and the fourth sub-pixel P4, the first active layer 21 and the third active layer 23 may be provided on a side of the first plate 61of the current sub-pixel in the opposite direction of the extension direction of the second direction Y, and the second active layer 22 may be provided on a side of the first plate 61 of the current sub-pixel in the extension direction of the second direction Y.

In an exemplary implementation, for the third sub-pixel P3, the first active layer 21 may be provided on a side of the third sub-pixel P3 away from the fourth sub-pixel P4, and the third active layer 23 may be provided on a side of the third sub-pixel P3 close to the fourth sub-pixel P4. For the fourth sub-pixel P4, the first active layer 21 may be provided on a side of the fourth sub-pixel P4 away from the third sub-pixel P3, and the third active layer 23 may be provided on a side of the fourth sub-pixel P4 close to the third sub-pixel P3.

In an exemplary implementation, an active layer of each transistor may include a first region, a second region, and a channel region located between the first region and the second region.

In an exemplary implementation, an orthographic projection of a first region of the first active layer 21 of each sub-pixel on the base substrate is at least partially overlapped with an orthographic projection of a corresponding data signal line 52 on the base substrate, and a second region of the first active layer 21 is connected to the second plate 62.

In an exemplary implementation, an orthographic projection of a first region of the second active layer 22 of each sub-pixel on the base substrate is not overlapped with an orthographic projection of the third connection electrode 13 of the current sub-pixel on the base substrate, and an orthographic projection of a second region and a channel region of the second active layer 22 on the base substrate is at least partially overlapped with the orthographic projection of the third connection electrode 13 on the base substrate, so that the third connection electrode 13 serving as a shield layer can shield the channel region of the second transistor T2, avoid influence of light on the channel, and ensure electrical performance of the second transistor T2.

In an exemplary implementation, in each sub-pixel, a distance between the first region of the second active layer 22 and a first power supply line 51 may be less than a distance between the second region of the second active layer 22 and the first power supply line 51, i.e., the first region of the second active layer 22 is closer to the first power supply line 51 than the channel region of the second active layer 22.

In an exemplary implementation, first regions of the second active layers 22 in two adjacent sub-pixels of two repetition units adjacent in the second direction Y may be connected to each other so that the second transistors in the two adjacent sub-pixels of the two repetition units adjacent in the second direction Y share the first region of the second active layer. For example, for a first repetition unit Q1 and a third repetition unit Q3 adjacent in the second direction Y, the first region of the second active layer 22 in the third sub-pixel P3 of the first repetition unit Q1 and the first region of the second active layer 22 in the first sub-pixel P1 of the third repetition unit Q3 may be connected to each other, and the first region of the second active layer 22 in the fourth sub-pixel P4 of the first repetition unit Q1 and the first region of the second active layer 22 in the second sub-pixel P2 of the third repetition unit Q3 may be connected to each other. For another example, for a second repetition unit Q2 and a fourth repetition unit Q4 adjacent in the second direction Y, the first region of the second active layer 22 in the third sub-pixel P3 of the second repetition unit Q2 and the first region of the second active layer 22 in the first sub-pixel P1 of the fourth repetition unit Q4 may be connected to each other, and the first region of the second active layer 22 in the fourth sub-pixel P4 of the second repetition unit Q2 and the first region of the second active layer 22 in the second sub-pixel P2 of the fourth repetition unit Q4 may be connected to each other.

In an exemplary implementation, the second active layers 22 in two adjacent sub-pixels of two repetition units adjacent in the second direction Y may be interconnected to form an integral structure, the second active layer 22 of the integral structure have a groove 92, and the openings of adjacent grooves 92 in at least one repetition unit are provided oppositely. The groove 92 may have a groove width and a groove depth, the groove width may be less than the groove depth, the groove width may be a dimension in the second direction Y, and the groove depth may be a dimension in the first direction X. By providing the second transistors in two adjacent sub-pixels of two repetition units adjacent in the second direction Y to share the first region of the second active layer according to the present disclosure, not only a quantity of vias can be effectively reduced, the area occupied by the pixel drive circuits can be reduced, the pixel aperture ratio can be increased, and the display resolution can be improved, but also manufacturing process can be simplified by the reduced quantity of the vias, a production cost can be reduced, and a product yield can be improved.

In an exemplary implementation, widths of the second active layers in the sub-pixels adjacent in the first direction X may be different, and widths of the second active layers in the sub-pixels adjacent in the second direction Y may be different, and a width is a minimum dimension of the second active layer in the second direction Y.

In an exemplary implementation, in the first direction X, multiple sub-pixels having the second active layers with greater widths and multiple sub-pixels having the second active layers with smaller widths may be alternately provided. For example, a first sub-pixel P1 and a second sub-pixel P2 are alternately provided in the first direction X, and a first width L1 of the second active layer 22 in the first sub-pixel P1 may be greater than a second width L2 of the second active layer 22 in the second sub-pixel P2. For another example, a third sub-pixel P3 and a fourth sub-pixel P4 are alternately provided in the first direction X, and a third width L3 of the second active layer 22 in the third sub-pixel P3 may be less than a fourth width L4 of the second active layer 22 in the fourth sub-pixel P4.

In an exemplary implementation, in the second direction Y, multiple sub-pixels having the second active layers with greater widths and multiple sub-pixels having the second active layers with smaller widths may be alternately provided. For example, a first sub-pixel P1 and a third sub-pixel P3 are alternately provided in the second direction Y, and a first width L1 of the second active layer 22 in the first sub-pixel P1 may be greater than a third width L3 of the second active layer 22 in the third sub-pixel P3. For another example, a second sub-pixel P2 and a fourth sub-pixel P4 are alternately provided in the second direction Y, and a second width L2 of the second active layer 22 in the second sub-pixel P2 may be less than a fourth width L4 of the second active layer 22 in the fourth sub-pixel P4.

In an exemplary implementation and in at least one repetition unit, the widths of the second active layers 22 of the four sub-pixels may be different. For example, the first width L1 of the second active layer 22 in the first sub-pixel P1 may be greater than the fourth width L4 of the second active layer 22 in the fourth sub-pixel P4. For another example, the second width L2 of the second active layer 22 in the second sub-pixel P2 may be greater than the third width L3 of the second active layer 22 in the third sub-pixel P3.

In an exemplary implementation, by providing a second active layer with a greater width and a second active layer with a smaller width are alternately provided in the first direction X and the second direction Y according to the present disclosure, not only requirements of a structure of a single scan signal line can be effectively matched, but also uniformity of a layout of a four-pixel drive circuit in a repetition unit can be effectively increased and uniformity of pixel openings of four sub-pixels in the repetition unit can be effectively increased.

In an exemplary implementation, an orthographic projection of a first region of the third active layer 23 of each sub-pixel on the base substrate is at least partially overlapped with an orthographic projection of a compensation signal line 53 on the base substrate, and an orthographic projection of a second region of the third active layer 23 on the base substrate is at least partially overlapped with an orthographic projection of the fourth connection electrode 14 of the current sub-pixel on the base substrate.

In an exemplary implementation, in at least one repetition unit, the first region of the third active layer 23 in the first sub-pixel P1 and the first region of the third active layer 23 in the second sub-pixel P2 may be connected to each other, and the first region of the third active layer 23 in the third sub-pixel P3 and the first region of the third active layer 23 in the fourth sub-pixel P4 may be connected to each other.

In an exemplary implementation, the third active layer 23 in the first sub-pixel P1 and the third active layer 23 in the second sub-pixel P2 may be interconnected to form an integral structure, and the third active layer 23 in the third sub-pixel P3 and the third active layer 23 in the fourth sub-pixel P4 may be interconnected to form an integral structure, so that third transistors of two adjacent sub-pixels in one pixel row share the first region of the third active layer. By providing the third transistors of two adjacent sub-pixels in a pixel row to share the first region of the third active layer according to the present disclosure, not only the quantity of vias can be effectively reduced, the area occupied by the pixel drive circuits can be reduced, the pixel aperture ratio can be increased, and the display resolution can be improved, but also manufacturing process can be simplified by the reduced quantity of the vias, the production cost can be reduced, and the product yield can be improved.

In an exemplary implementation, the second plate 62 may have a shape of a rectangle, corners of the rectangle may be chamfered, and the second plate 62 may be disposed between the second active layer 22 and the third active layer 23 of the current sub-pixel. An orthographic projection of the second plate 62 on the base substrate is at least partially overlapped with an orthographic projection of the first plate 61 on the base substrate, the second plate 62 may be another transparent plate of a transparent storage capacitor, and the first plate 61 and the second plate 62 form the transparent storage capacitor.

In an exemplary implementation, the second plate 62 and the first active layer 21 of each sub-pixel may be interconnected to form an integral structure.

In an exemplary implementation, in each sub-pixel, an area of an overlapping area between the orthographic projection of the first plate 61 on the base substrate and the orthographic projection of the second plate 62 on the base substrate may be substantially the same so that a capacity of the storage capacitor in each sub-pixel is substantially the same.

In an exemplary implementation, the semiconductor layer may be made of a metal oxide such as an oxide containing indium and tin, an oxide containing tungsten and indium, an oxide containing tungsten, indium and zinc, an oxide containing titanium and indium, an oxide containing titanium, indium and tin, an oxide containing indium and zinc, an oxide containing silicon, indium and tin, an oxide containing indium, gallium and zinc, etc. The semiconductor layer may be a single layer, two layers, or multiple layers.

In an exemplary implementation, in at least one repetition unit, positions of the respective patterns in the semiconductor layer in the first sub-pixel P1 and positions of the respective patterns in the semiconductor layer in the third sub-pixel P3 may be substantially mirror-symmetrical with respect to the horizontal reference line. Positions of the respective patterns in the semiconductor layer in the second sub-pixel P2 and positions of the respective patterns in the semiconductor layer in the fourth sub-pixel P4 may be substantially mirror-symmetrical with respect to the horizontal reference line. Positions of the respective patterns in the semiconductor layer in the first sub-pixel P1 and the positions of the respective patterns in the semiconductor layer in the second sub-pixel P2 may be substantially mirror-symmetrical with respect to the vertical reference line. Positions of the respective patterns in the semiconductor layer in the third sub-pixel P3 and positions of the respective patterns in the semiconductor layer in the fourth sub-pixel P4 may be substantially mirror-symmetrical with respect to the vertical reference line.

(14) A pattern of a second insulation layer is formed. In an exemplary implementation, forming the pattern of the second insulation layer may include depositing a second insulation thin film on the base substrate on which the aforementioned patterns are formed, patterning the second insulation thin film by a patterning process to form the second insulation layer that covers the semiconductor layer, wherein multiple vias are provided on the second insulation layer, as shown in FIG. 8.

In an exemplary implementation, the multiple vias of each sub-pixel in each repetition unit at least includes a first via V1, a second via V2, a third via V3, a fourth via V4, a fifth via V5, a sixth via V6, and a seventh via V7.

In an exemplary implementation, an orthographic projection of the first via V1 on the base substrate is within a range of an orthographic projection of the first region of the first active layer 21 and a data signal line 52 on the base substrate. The first via V1 is a via having a switch structure, including a shallow half hole and a deep half hole. The second insulation layer in the shallow half hole is etched away to expose a surface of the first region of the first active layer 21. The first insulation layer and the second insulation layer in the deep half hole are etched away to expose a surface of the data signal line 52 so that the via having the switch structure composed of the two half holes simultaneously exposes the first region of the first active layer 21 and the data signal line 52. The first via V1 is configured to connect the seventh connection electrode to be formed subsequently to the first region of the first active layer 21 and the data signal line 52 through the first via V1.

In an exemplary implementation, an orthographic projection of the second via V2 on the base substrate is within a range of an orthographic projection of the first region of the second active layer 22 on the base substrate, the second insulation layer within the second via V2 is etched away to expose a surface of the first region of the second active layer 22, and the second via V2 is configured to connect a power supply connection electrode to be formed subsequently to the first region of the second active layer 22 through the second via V2. In an exemplary implementation, the second via V2 serves as an active via of this embodiment.

In an exemplary implementation, since first regions of the second active layers 22 in two adjacent sub-pixels of two repetition units adjacent in the second direction Y are connected to each other, the two adjacent sub-pixels of the two repetition units adjacent in the second direction Y may share the same second via V2. For example, the third sub-pixel P3 of the first repetition unit Q1 and the first sub-pixel P1 of the third repetition unit Q3 share the same second via V2. For another example, the fourth sub-pixel P4 of the first repetition unit Q1 and the second sub-pixel P2 of the third repetition unit Q2 share the same second via V2. By providing two adjacent sub-pixels in two adjacent repetition units to share the same second via according to the present disclosure, not only a quantity of the vias can be effectively reduced, the area occupied by the pixel drive circuits can be reduced, the pixel aperture ratio can be increased, and the display resolution can be improved, but also manufacturing process can be simplified by the reduced quantity of the vias, the production cost can be reduced, and the product yield can be improved.

In an exemplary implementation, an orthographic projection of the third via V3 on the base substrate is within a range of an orthographic projection of the second region of the second active layer 22 and the third connection electrode 13 on the base substrate. The third via V3 is a via having a switch structure, including a shallow half hole and a deep half hole. The second insulation layer in the shallow half hole is etched away to expose a surface of the second region of the second active layer 22. The first insulation layer and the second insulation layer in the deep half hole are etched away to expose a surface of the third connection electrode 13, so that the via having the switch structure composed of the two half holes simultaneously exposes the second region of the second active layer 22 and the third connection electrode 13. The third via V3 is configured to connect the fifth connection electrode to be formed subsequently to the second region of the second active layer 22 and the third connection electrode 13 through the third via V3.

In an exemplary implementation, an orthographic projection of the fourth via V4 on the base substrate is within a range of an orthographic projection of the first region of the third active layer 23 and the compensation signal line 53 on the base substrate. The fourth via V4 is a via having a switch structure, including a shallow half hole and a deep half hole. The second insulation layer in the shallow half hole is etched away to expose a surface of the first region of the third active layer 23. The first insulation layer and the second insulation layer in the deep half hole are etched away to expose a surface of the compensation signal line 53, so that the via having the switch structure composed of the two half holes simultaneously exposes the first region of the third active layer 23 and the compensation signal line 53. The fourth via V4 is configured to connect an eighth connection electrode to be formed subsequently to the first region of the third active layer 23 and the compensation signal line 53 through the fourth via V4.

In an exemplary implementation, since first regions of the third active layers in the first sub-pixel P1 and the second sub-pixel P2 of the repetition unit are connected to each other, and first regions of the third active layers in the third sub-pixel P3 and the fourth sub-pixel P4 are connected to each other, the first sub-pixel P1 and the second sub-pixel P2 of the repetition unit may share the same fourth via V4, and the third sub-pixel P3 and the fourth sub-pixel P4 of the repetition unit may share the same fourth via V4. By providing adjacent sub-pixels to share the same fourth via V4 according to the present disclosure, not only the quantity of vias can be effectively reduced, the area occupied by the pixel drive circuits can be reduced, the pixel aperture ratio can be increased, and the display resolution can be improved, but also manufacturing process can be simplified by the reduced quantity of the vias, the production cost can be reduced, and a the product yield can be improved.

In an exemplary implementation, an orthographic projection of the fifth via V5 on the base substrate is within a range of an orthographic projection of the second region of the third active layer 23 and the fourth connection electrode 14 on the base substrate. The fifth via V5 is a via having a switch structure, including a shallow half hole and a deep half hole. The second insulation layer in the shallow half hole is etched away to expose a surface of the second region of the third active layer 23, the first insulation layer and the second insulation layer in the deep half hole are etched away to expose a surface of the fourth connection electrode 14, so that the via having the switch structure composed of the two half holes simultaneously exposes the second region of the third active layer 23 and the fourth connection electrode 14, and the fifth via V5 is configured to connect the sixth connection electrode to be formed subsequently to the second region of the third active layer 23 and the fourth connection electrode 14 through the fifth via V5.

In an exemplary implementation, an orthographic projection of the sixth via V6 on the base substrate is within a range of an orthographic projection of the second plate 62 on the base substrate, the second insulation layer in the sixth via V6 is etched away to expose a surface of the second plate 62, and the sixth via V6 is configured to connect the second gate electrode to be formed subsequently to the second plate 62 through the sixth via V6.

In an exemplary implementation, an orthographic projection of the seventh via V7 on the base substrate is within a range of an orthographic projection of the first power supply line 51 on the base substrate, the first insulation layer and the second insulation layer in the seventh via V7 are etched away to expose a surface of the first power supply line 51, and the seventh via V7 is configured to connect the power supply connection electrode to be formed subsequently to the first power supply line 51 through the seventh via V7. In an exemplary implementation, the seventh via V7 serves as a power supply via of this embodiment.

In an exemplary implementation, two adjacent sub-pixels of two repetition units adjacent in the first direction X share the same seventh via V7. For example, the second sub-pixel P2 of the first repetition unit Q1 and the first sub-pixel P1 of the second repetition unit Q2 share the same seventh via V7. For another example, the fourth sub-pixel P4 of the first repetition unit Q1 and the third sub-pixel P3 of the second repetition unit Q2 share the same seventh via V7. By providing two adjacent sub-pixels of two repetition units adjacent in the first direction X to share the same seventh via V7 according to the present disclosure, not only the quantity of vias can be effectively reduced, the area occupied by the pixel drive circuits can be reduced, the pixel aperture ratio can be increased, and the display resolution can be improved, but also manufacturing process can be simplified by the reduced quantity of the vias, the production cost can be reduced, and the product yield can be improved.

In an exemplary implementation, two adjacent sub-pixels of two repetition units adjacent in the second direction Y share the same seventh via V7. For example, the third sub-pixel P3 of the first repetition unit Q1 and the first sub-pixel P1 of the third repetition unit Q3 share the same seventh via V7. For another example, the fourth sub-pixel P4 of the first repetition unit Q1 and the second sub-pixel P2 of the third repetition unit Q2 share the same seventh via V7. By providing two adjacent sub-pixels of two repetition units adjacent in the second direction Y to share the same seventh via V7 according to the present disclosure, not only the quantity of vias can be effectively reduced, the area occupied by the pixel drive circuits can be reduced, the pixel aperture ratio can be increased, and the display resolution can be improved, but also manufacturing process can be simplified by the reduced quantity of the vias, the production cost can be reduced, and the product yield can be improved.

In an exemplary implementation, adjacent sub-pixels in repetition units adjacent in the first direction X and the second direction Y share the same seventh via V7, i.e., the four adjacent sub-pixels of the adjacent repetition units share the same seventh via V7. For example, for a first repetition unit Q1 and a second repetition unit Q2 adjacent in the first direction X, the fourth sub-pixel P4 of the first repetition unit Q1 and the third sub-pixel P3 of the second repetition unit Q2 are two adjacent sub-pixels. For a third repetition unit Q3 and a fourth repetition unit Q4 adjacent in the first direction X, the second sub-pixel P2 of the third repetition unit Q3 and the first sub-pixel P1 of the fourth repetition unit Q4 are two adjacent sub-pixels. For a first repetition unit Q1 and a third repetition unit Q3 adjacent in the second direction Y, the fourth sub-pixel P4 of the first repetition unit Q1 and the second sub-pixel P2 of the third repetition unit Q3 are two adjacent sub-pixels. For a second repetition unit Q2 and a fourth repetition unit Q4 adjacent in the second direction Y, the third sub-pixel P3 of the second repetition unit Q2 and the first sub-pixel P1 of the fourth repetition unit Q4 are two adjacent sub-pixels. The fourth sub-pixel P4 of the first repetition unit Q1, the third sub-pixel P3 of the second repetition unit Q2, the second sub-pixel P2 of the third repetition unit Q3, and the first sub-pixel P1 of the fourth repetition unit Q4 share the same seventh via V7. By providing the four adjacent sub-pixels of the adjacent repetition units to share the same seventh via V7 according to the present disclosure, not only the quantity of vias can be effectively reduced, the area occupied by the pixel drive circuits can be reduced, the pixel aperture ratio can be increased, and the display resolution can be improved, but also manufacturing process can be simplified by the reduced quantity of the vias, the production cost can be reduced, and the product yield can be improved.

In an exemplary implementation, in a process of forming the pattern of the second insulation layer, multiple vias are formed by a dry etching process, and a first conductorization treatment is performed on the semiconductor layer exposed by the vias, so that the semiconductor layer exposed by the vias forms a first conductorized area. During the first conductorization process, an edge portion of the semiconductor layer covered by the second insulation layer close to a via is also conductorized, i.e., the semiconductor layer after the first conductorization extends in a direction away from the vias.

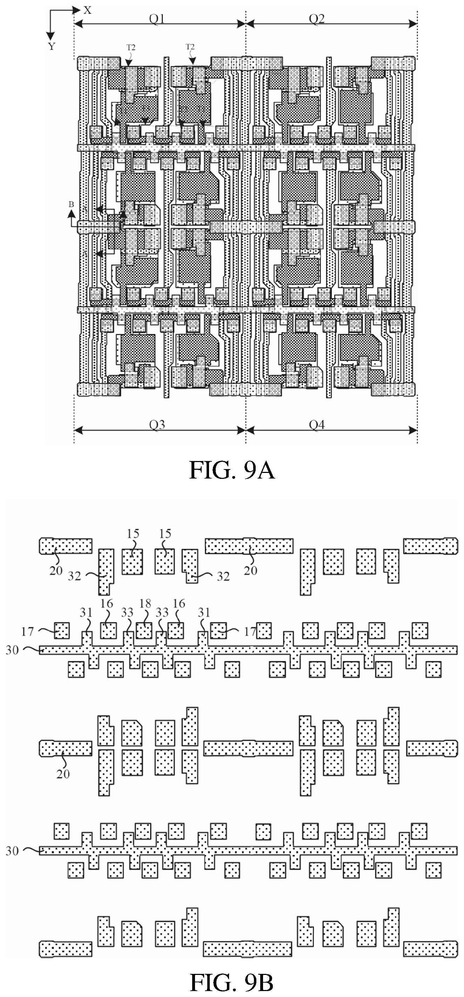

(15) A pattern of a third conductive layer is formed. In an exemplary implementation, forming the pattern of the third conductive layer may include depositing a third conductive thin film on the base substrate on which the aforementioned patterns are formed, patterning the third conductive thin film by a patterning process to form the pattern of the third conductive layer on the second insulation layer, as shown in FIG. 9A and FIG. 9B, and FIG. 9B is a schematic diagram of the third conductive layer in FIG. 9A. In an exemplary implementation, the third conductive layer may be referred to as a gate metal (GT) layer.

In an exemplary implementation, the third conductive layer of each sub-pixel in each repetition unit may at least include a fifth connection electrode 15, a sixth connection electrode 16, a seventh connection electrode 17, an eighth connection electrode 18, a power supply connection electrode 20, a scan signal line 30, a first gate electrode 31, a second gate electrode 32, and a third gate electrode 33.

In an exemplary implementation, the scan signal line 30 may have a shape of a line with a main body portion extending along the first direction X and may be provided in the middle of the second direction Y of the repetition unit, i.e., between the first sub-pixel P1 with the second sub-pixel P2 and the third sub-pixel P3 with the fourth sub-pixel P4, and the scan signal line 30 is configured to simultaneously control turn-on or turn-off of all the first transistors T1 and all the third transistors T3 in the four sub-pixels of the repetition unit.

In an exemplary implementation, an orthographic projection of the scan signal line 30 on the base substrate is not overlapped with an orthographic projection of the first active layer 21 and the third active layer 23 on the base substrate.

In an exemplary implementation, the first gate electrode 31 may have a shape of a strip extending along the second direction Y, and may be provided on a side of the scan signal line 30 close to the first active layer 21. A first end of the first gate electrode 31 is connected to the scan signal line 30, a second end of the first gate electrode 31 extends in a direction towards the first active layer 21, and an orthographic projection of the first gate electrode 31 on the base substrate is at least partially overlapped with an orthographic projection of the first active layer 21 on the base substrate. In an exemplary implementation, the first gate electrode 31 may serve as a gate electrode of the first transistor T1 so that the scan signal line 30 may control turn-on or turn-off of the first transistor T1.

In an exemplary implementation, the second gate electrode 32 may have a shape of a strip extending along the second direction Y. A first end of the second gate electrode 32 is connected to the second plate 62 through the sixth via V6, a second end of the second gate electrode 32 extends in a direction towards the second active layer 22, and an orthographic projection of the second gate electrode 32 on the base substrate is at least partially overlapped with an orthographic projection of the second active layer 22 on the base substrate. In an exemplary implementation, the second gate electrode 32 may serve as a gate electrode of the second transistor T2 and may control turn-on or turn-off of the second transistor T2.

In an exemplary implementation, since the second gate electrode 32 is connected to the second plate 62 and the second plate 62 is connected to the second region of the first active layer 21, it is achieved that the second electrode of the first transistor T1, the gate electrode of the second transistor T2 and the second plate 62 (the first end of the storage capacitor) have a same potential, so that a first node in the pixel drive circuit is formed, and the second plate 62 has a potential of the first node in the pixel drive circuit.

In an exemplary implementation, the third gate electrode 33 may have a shape of a strip extending along the second direction Y, and may be provided on a side of the scan signal line 30 close to the third active layer 23. A first end of the third gate electrode 33 is connected to the scan signal line 30, a second end of the third gate electrode 33 extends in a direction towards the third active layer 23, and an orthographic projection of the third gate electrode 33 on the base substrate is at least partially overlapped with an orthographic projection of the third active layer 23 on the base substrate. In an exemplary implementation, the third gate electrode 33 may serve as a gate electrode of the third transistor T3 so that the scan signal line 30 may control turn-on or turn-off of the third transistor T3.

In an exemplary implementation, in one sub-pixel, one scan signal line 30 is simultaneously connected to the first gate electrode 31 and the third gate electrode 33 so that the scan signal line 30 can control turn-on or turn-off of the first transistor T1 and the third transistor T3 in the sub-pixel.

In an exemplary implementation, in one pixel row, one scan signal line 30 is simultaneously connected to all the first gate electrodes 31 and all the third transistors 33 in multiple sub-pixels so that the scan signal line 30 can control turn-on or turn-off of all the first transistors T1 and all the third transistors T3 in the pixel row.

In an exemplary implementation, in one repetition unit, one scan signal line 30 is simultaneously connected to all the first gate electrodes 31 and all the third transistors 33 in multiple sub-pixels so that the scan signal line 30 can simultaneously control turn-on or turn-off of all the first transistors T1 and all the third transistors T3 in the repetition unit.

In an exemplary implementation, the fifth connection electrode 15 may have a shape of a block (for example, a rectangle), may be provided on a side of the second plate 62 away from the scan signal line 30, and the fifth connection electrode 15 is simultaneously connected to the second region of the second active layer 22 and the third connection electrode 13 through the third via V3.

In an exemplary implementation, since the fifth connection electrode 15 is simultaneously connected to the second region of the second active layer 22 and the third connection electrode 13, the third connection electrode 13 is connected to the first connection electrode 11, and the first connection electrode 11 is connected to the first plate 61, the fifth connection electrode 15 enables the second electrode of the second transistor and the first plate 61 to have a same potential. In an exemplary implementation, the seventh connection electrode 15 is configured to be connected to an anode connection electrode to be formed subsequently.

In an exemplary implementation, the sixth connection electrode 16 may have a shape of a block (for example, a rectangle) and may be provided on a side of the second plate 62 close to the scan signal line 30, and the sixth connection electrode 16 is simultaneously connected to the second region of the third active layer 23 and the fourth connection electrode 14 through the fifth via V5.

In an exemplary implementation, since the sixth connection electrode 16 is simultaneously connected to the second region of the third active layer 23 and the fourth connection electrode 14, the fourth connection electrode 14 is connected to the second connection electrode 12, and the second connection electrode 12 is connected to the first plate 61, the sixth connection electrode 16 enables the second electrode of the third transistor and the first plate 61 to have the same potential.

In an exemplary implementation, connection between the second electrode of the second transistor, the second electrode of the third transistor, and the first plate 61 (the second end of the storage capacitor) is achieved by the fifth connection electrode 15 and the sixth connection electrode 16, and a second node in the pixel drive circuit is formed, so that the first plate 61 has a potential of the second node in the pixel drive circuit.

In an exemplary implementation, since the first plate 61 has the potential of the second node in the pixel drive circuit and the second plate 62 has the potential of the first node in the pixel drive circuit, the first plate 61 with the potential of the second node and the second plate 62 with the potential of the first node form a storage capacitor.

In an exemplary implementation, since the first plate 61 is made of a transparent conductive material and the second plate 62 is made of a transparent metal oxide, the storage capacitor is a transparent capacitor.

In an exemplary implementation, the seventh connection electrode 17 may have a shape of a block (for example, a rectangle) and may be provided between the first gate electrode 31 and the first power supply line 51, and the seventh connection electrode 17 is simultaneously connected to the first region of the first active layer 21 and the data signal line 52 through the first via V1, thereby achieving that a data signal is written to the first electrode of the first transistor T1 by the data signal line 52. In an exemplary implementation, each data signal line 52 may be connected to the first region of the first active layer in a sub-pixel through the first via V1, thereby realizing that four data signal lines 52 respectively write data signals to first electrodes of first transistors T1 in multiple repetition units arranged along the second direction Y.

In an exemplary implementation, the four data signal lines 52 may include a first data signal line, a second data signal line, a third data signal line, and a fourth data signal line. In each repetition unit, the first data signal line may be connected to the first region of the first active layer of the first sub-pixel P1 through a seventh connection electrode 17, the second data signal line may be connected to the first region of the first active layer of the third sub-pixel P3 through a seventh connection electrode 17, the third data signal line may be connected to the first region of the first active layer of the second sub-pixel P2 through a seventh connection electrode 17, and the fourth data signal line may be connected to the first region of the first active layer of the fourth sub-pixel P4 through a seventh connection electrode 17.

In an exemplary implementation, the eighth connection electrode 18 may have a shape of a block (for example, a rectangle), may be provided between the third gate electrodes 33 of two adjacent sub-pixels in the first direction X, and is simultaneously connected to the first region of the third active layer 23 and the compensation signal line 53 through the fourth via V4, thereby achieving that a compensation signal is written to the first electrode of the third transistor T3 by the compensation signal line 53.

In an exemplary implementation, since the first regions of the third active layers in the first sub-pixel P1 and the second sub-pixel P2 of a repetition unit are connected to each other, and the first sub-pixel P1 and the second sub-pixel P2 share a same fourth via V4, the first sub-pixel P1 and the second sub-pixel P2 share a same eighth connection electrode 18. Since the first regions of the third active layers in the third sub-pixel P3 and the fourth sub-pixel P4 are connected to each other, and the third sub-pixel P3 and the fourth sub-pixel P4 share a same fourth via V4, the third sub-pixel P3 and the fourth sub-pixel P4 share a same eighth connection electrode 18. By providing the sub-pixels adjacent in the first direction X in the repetition unit to share the same eighth connection electrode according to the present disclosure, not only the quantity of vias can be effectively reduced, the area occupied by the pixel drive circuits can be reduced, the pixel aperture ratio can be increased, and the display resolution can be improved, but also manufacturing process can be simplified by the reduced quantity of of the connection electrodes, the production cost can be reduced, and the product yield can be improved.

In an exemplary implementation, in a repetition unit, the compensation signal line 53 may simultaneously supply a compensation signal to pixel drive circuits in the four sub-pixels so that the four pixel drive circuits in the repetition unit may share the compensation signal line 53, i.e., the compensation signal line 53 in the repetition unit has a one-for-four structure. By designing the compensation signal line with the one-for-four structure according to the present disclosure, the quantity of the signal lines is saved, an occupied space is reduced, structure is simple, layout is reasonable, layout space is fully utilized, a space utilization rate is improved, the pixel aperture ratio is increased, and the display resolution is improved.

In an exemplary implementation, the compensation signal line 53 is provided between the first pixel column and the second pixel column, and the third transistors T3 of the first pixel column and the third transistors T3 of the second pixel column are symmetrically provided with respect to the compensation signal line 53. This symmetrical structure according to the present disclosure can ensure that a RC delay of a compensation signal written to each third transistor T3 is substantially the same, ensuring display uniformity.

In an exemplary implementation, the power supply connection electrode 20 may have a shape of a strip extending along the first direction X and may be provided on the side of the second plate 62 away from the scan signal line 30. A first end of the power supply connection electrode 20 is connected to the first power supply line 51 through the seventh via V7, and a second end of the power supply connection electrode 20 is connected to the first region of the second active layer 22 through the second via V2, thereby achieving that the first power supply signal is written to the first electrode of the second transistor T2 by the first power supply line 51.

In an exemplary implementation, in each repetition unit, the first power supply line 51 of the first pixel column may simultaneously supply a first power supply signal to the pixel drive circuits in the first sub-pixel P1 and in the third sub-pixel P3, and the first power supply line 51 of the second pixel column may simultaneously supply a first power supply signal to the pixel drive circuits in the second sub-pixel P2 and in the fourth sub-pixel P4, therefore the first power supply line 51 in a repetition unit has a one-for-two structure. By designing the first power supply line with the one-for-two structure according to the present disclosure, the quantity of signal lines is saved, the occupied space is reduced, the structure is simple, the layout is reasonable, the layout space is fully utilized, the space utilization rate is improved, the pixel aperture ratio is increased, and the display resolution is improved.

In an exemplary implementation, two first power supply lines 51 in a repetition unit are symmetrically provided with respect to the compensation signal line 53, and the second transistors T2 of the first pixel column and the second transistors T2 of the second pixel column are symmetrically provided with respect to the compensation signal line 53. This symmetrical structure according to the present disclosure can ensure that a voltage drop of the first power supply line written to each second transistor T2 is substantially the same, ensuring display uniformity.

In an exemplary implementation, first ends of the power supply connection electrodes 20 in two adjacent sub-pixels of two repetition units adjacent in the first direction X may be connected to each other. For example, first ends of two power supply connection electrodes 20 in the second sub-pixel P2 of the first repetition unit Q1 and in the first sub-pixel P1 of the second repetition unit Q2 may be connected to each other. For another example, first ends of two power supply connection electrodes 20 in the fourth sub-pixel P4 of the first repetition unit Q1 and in the third sub-pixel P3 of the second repetition unit Q2 may be connected to each other.

In an exemplary implementation, the power supply connection electrodes 20 in two adjacent sub-pixels of two repetition units adjacent in the first direction X may be interconnected to form an integral structure.

In an exemplary implementation, since second transistors in two adjacent sub-pixels of two repetition units adjacent in the second direction Y share the first region of the second active layer, and two adjacent sub-pixels of two repetition units adjacent in the second direction Y share the same second via V2, the two adjacent sub-pixels of two repetition units adjacent in the second direction Y share the same power supply connection electrode 20. For example, the third sub-pixel P3 of the first repetition unit Q1 and the first sub-pixel P1 of the third repetition unit Q3 share the same power supply connection electrode 20. For another example, the fourth sub-pixel P4 of the first repetition unit Q1 and the second sub-pixel P2 of the third repetition unit Q2 share the same power supply connection electrode 20. By providing the two sub-pixels of repetition units adjacent in the second direction Y share the same power supply connection electrode according to the present disclosure, not only the quantity of vias can be effectively reduced, the area occupied by the pixel drive circuits can be reduced, the pixel aperture ratio can be increased, and the display resolution can be improved, but also manufacturing process can be simplified by the reduced quantity of the connection electrodes, the production cost can be reduced, and the product yield can be improved.

In an exemplary implementation, in at least one repetition unit, positions of the respective patterns in the third conductive layer in the first sub-pixel P1 and positions of the respective patterns in the third conductive layer in the third sub-pixel P3 may be substantially mirror-symmetrical with respect to the horizontal reference line. Positions of the respective patterns in the third conductive layer in the second sub-pixel P2 and positions of the respective patterns in the third conductive layer in the fourth sub-pixel P4 may be substantially mirror-symmetrical with respect to the horizontal reference line. Positions of the respective patterns in the third conductive layer in the first sub-pixel P1 and the positions of the respective patterns in the third conductive layer in the second sub-pixel P2 may be substantially mirror-symmetrical with respect to the vertical reference line. Positions of the respective patterns in the third conductive layer in the third sub-pixel P3 and positions of the respective patterns in the third conductive layer in the fourth sub-pixel P4 may be substantially mirror-symmetrical with respect to the vertical reference line.

In an exemplary implementation, in a process of forming the pattern of the third conductive layer, a wet etching process is first adopted to form the pattern of the third conductive layer, so that at least one connection electrode is simultaneously connected to the second conductive layer and the semiconductor layer through a via of the switch structure. The via of the switch structure may at least include two half holes: a shallow half hole and a deep half hole. The second insulation layer in the shallow half hole is removed to expose a surface of the semiconductor layer, the second insulation layer and the first insulation layer in the deep half hole are removed to expose a surface of the second conductive layer, thereby achieving that the connection electrode is simultaneously connected to the semiconductor layer and the second conductive layer by the shallow half hole and the deep half hole. In an exemplary implementation, a distance is provided between an end of the connection electrode and an edge of the shallow half hole in an area of the shallow half hole, i.e., the connection electrode does not fully cover the shallow half hole.

In an exemplary implementation, after forming the pattern of the third conductive layer by the wet etching process, the second insulation layer in an area other than the third conductive layer is etched by a dry etching process in a self-alignment process using the third conductive layer as a mask, and a second conductorization is performed on the exposed semiconductor layer while the second insulation layer is etched away, forming a second conductorized area.

In an exemplary implementation, during the second conductorization process, an edge portion of the semiconductor layer covered by the third conductive layer is also conductorized, i.e., the semiconductor layer after the second conductorization extends to a first conductorized area, and a double conductorized area is formed in an overlapping area of the first conductorized area and a second conductorized area, so that a reliable connection between the third conductive layer and the semiconductor layer can be ensured.

In an exemplary implementation, for the power supply connection electrode 20 connected to the first region of the second active layer 22 through the second via V2 and the second gate electrode 32 connected to the second plate 62 through the sixth via V6, the power supply connection electrode 20 and the second gate electrode 32 do not fully cover the vias, and a distance is provided between an edge of a connection electrode and an edge of the corresponding via.

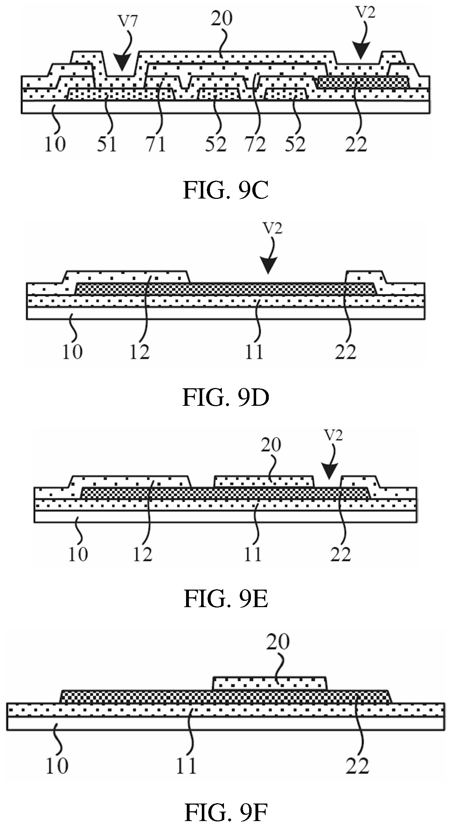

FIG. 9C is a cross-sectional view taken along direction A-A in FIG. 9A and FIG. 9D to FIG. 9F are cross-sectional views taken along direction B-B in FIG. 9A. In a direction perpendicular to the display substrate, the display substrate may at least include a second conductive layer, a first insulation layer 71, a semiconductor layer, a second insulation layer 72, and a third conductive layer that are sequentially disposed on the base substrate 10. The second conductive layer may at least include a first power supply line 51 and a data signal line 52, the semiconductor layer may at least include a second active layer 22, and the third conductive layer may at least include a power supply connection electrode 20.

In an exemplary implementation, a first end of the power supply connection electrode 20 is connected to the first power supply line 51 through the seventh via V7, and a second end of the power supply connection electrode 20 is connected to the second active layer 22 through the second via V2, as shown in FIG. 9C.

In an exemplary implementation, in the process of forming the pattern of the second insulation layer, the second insulation layer in the second via V2 is etched away to expose a surface of the second active layer 22, while the semiconductor layer exposed by the second via V2 is subjected to a first conductorization treatment, so that the semiconductor layer exposed by the second via V2 forms a first conductorized area, as shown in FIG. 9D.

In an exemplary implementation, in the process of forming the pattern of the third conductive layer, the third conductive layer including the power supply connection electrode 20 is firstly formed by a wet etching process, and the power supply connection electrode 20 is connected to the second active layer 22 through the second via V2, as shown in FIG. 9E. Then, in a self-alignment process using the third conductive layer as a mask, the second insulation layer 72 in an area other than the third conductive layer is etched by a dry etching process, and the exposed semiconductor layer is subjected to a second conductorization while the second insulation layer 72 is etched away, forming a second conductorized area, as shown in FIG. 9F.

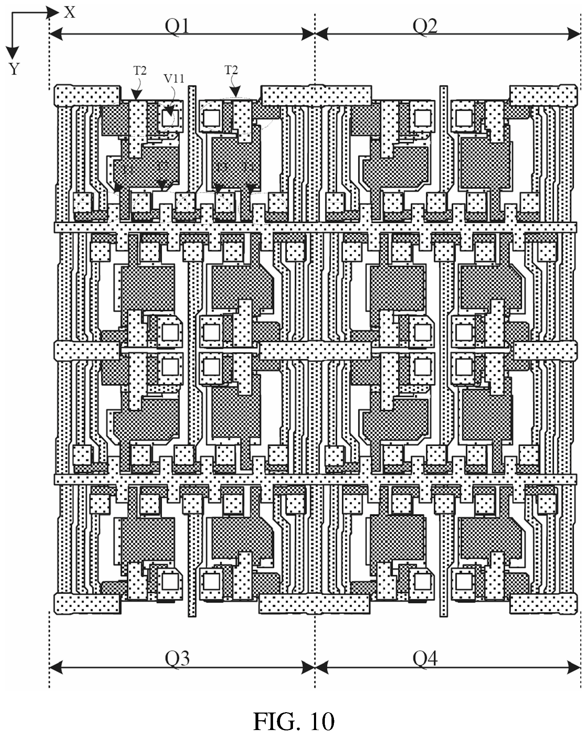

(16) Patterns of a third insulation layer and a planarization layer are formed. In an exemplary implementation, forming the patterns of the third insulation layer and the planarization layer may include first depositing a third insulation thin film on the base substrate on which the aforementioned patterns are formed, then coating a planarization thin film, and patterning the planarization thin film and the third insulation thin film by a patterning process to form the third insulation layer that covers the third conductive layer and the pattern of the planarization layer provided on the third insulation layer, and the planarization layer is provided with multiple vias, as shown in FIG. 10.

In an exemplary implementation, vias of each sub-pixel in each repetition unit at least includes an eleventh via V11.

In an exemplary implementation, an orthographic projection of the eleventh via V11 on the base substrate is within a range of an orthographic projection of the fifth connection electrode 15 on the base substrate, the third insulation layer and the planarization layer within the eleventh via V11 are etched away to expose a surface of the fifth connection electrode 15, and the eleventh via V11 is configured such that a anode connection electrode to be formed subsequently is connected to the fifth connection electrode 15 through the eleventh via V11.

In an exemplary implementation, this process adopts a one-time patterning process to simultaneously form vias on the third insulation layer and the planarization layer, i.e., a MASK plate (MASK) process in which the third insulation layer and the planarization layer share one-time halftone or gray tone, and times of patterning processes is effectively reduced.

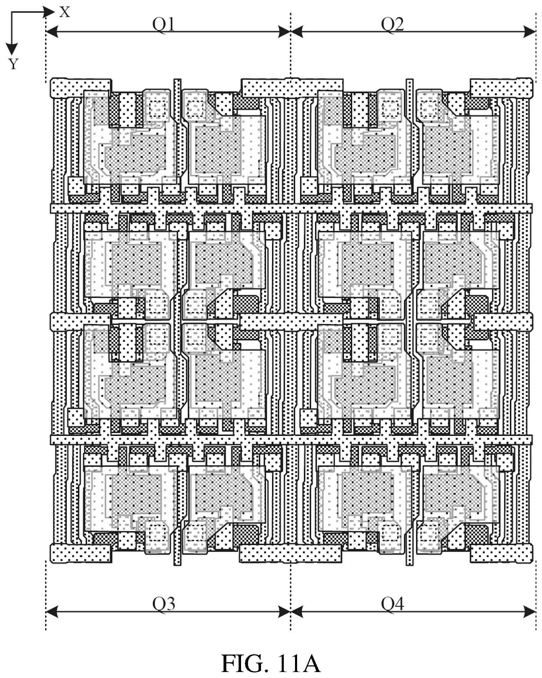

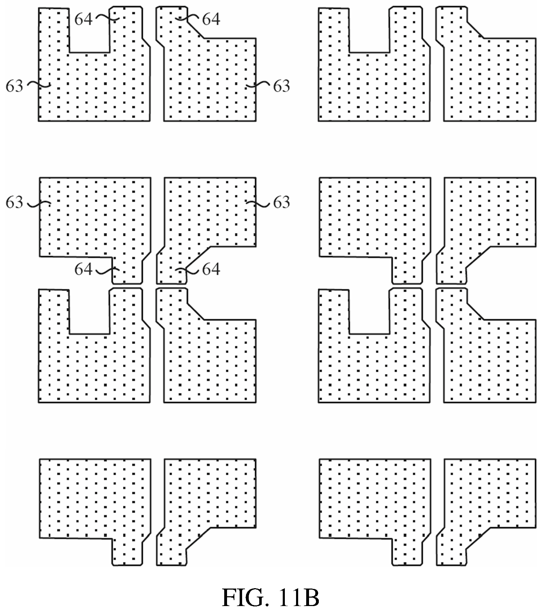

(17) A pattern of a fourth conductive layer is formed. In an exemplary implementation, forming the pattern of the fourth conductive layer may include depositing a fourth conductive thin film on the base substrate on which the aforementioned patterns are formed, patterning the fourth conductive thin film by a patterning process to form the pattern of the fourth conductive layer on a color filter layer, as shown in FIG. 11A and FIG. 11B, and FIG. 11B is a schematic diagram of the fourth conductive layer in FIG. 11A.

In an exemplary implementation, the fourth conductive layer of each sub-pixel in each repetition unit may at least include a first electrode 63 and an anode connection electrode 64.

In an exemplary implementation, the first electrode 63 may have a shape of a rectangle, corners of the rectangle may be provided with chamfers, grooves or protrusions, and an orthographic projection of the first electrode 63 on the base substrate is at least partially overlapped with an orthographic projection of the second plate 62 on the base substrate.

In an exemplary implementation, the anode connection electrode 64 may have a shape of a block (for example, a rectangle), may be on a side of the first electrode 63 away from the scan signal line 30, a first end of the anode connection electrode 64 is connected to the first electrode 63, a second end of the anode connection electrode 64 extends in a direction away from the scan signal line 30, and is connected to the fifth connection electrode 15 through the eleventh via V11.

In an exemplary implementation, in at least one sub-pixel, the anode connection electrode 64 and the first electrode 63 may be interconnected to form an integral structure.

In an exemplary implementation, in at least one repetition unit, four first electrodes 63 may be arranged in a square, the upper left first electrode is connected to the pixel drive circuit in the first sub-pixel P1, the upper right first electrode is connected to the pixel drive circuit in the second sub-pixel P2, the lower left first electrode is connected to the pixel drive circuit in the third sub-pixel P3, and the lower right first electrode is connected to the pixel drive circuit in the fourth sub-pixel P4. In some possible implementations, the first electrode may serve as an anode of the light emitting device, and an arrangement of the first electrodes may be adjusted according to actual needs, which is not limited here in the present disclosure.

In an exemplary implementation, the first conductive layer may be made of a transparent conductive material, such as Indium Tin Oxide (ITO) or Indium Zinc Oxide (IZO).

In an exemplary implementation, the first electrode 63 may also serve as an auxiliary capacitor for the storage capacitor. Since the first electrode 63 is connected to the anode connection electrode 64, the anode connection electrode 64 is connected to the first electrode 61 through the fifth connection electrode 15, the third connection electrode 13, and the first connection electrode 11, the first electrode 63 has a potential of the second node in the pixel drive circuit, so that the first electrode 63 with the potential of the second node and the second plate 62 with a potential of the first node form the auxiliary capacitor, and the auxiliary capacitor and the storage capacitor are connected in parallel. The present disclosure utilizes the first electrode to form the auxiliary capacitor, and the auxiliary capacitor and the storage capacitor are connected in parallel, so that on one hand, a capacitance value of the storage capacitor can be effectively increased, on the other hand, an plate area can be reduced under a condition of ensuring the capacitance value of the storage capacitor, and an occupied area can be effectively reduced.

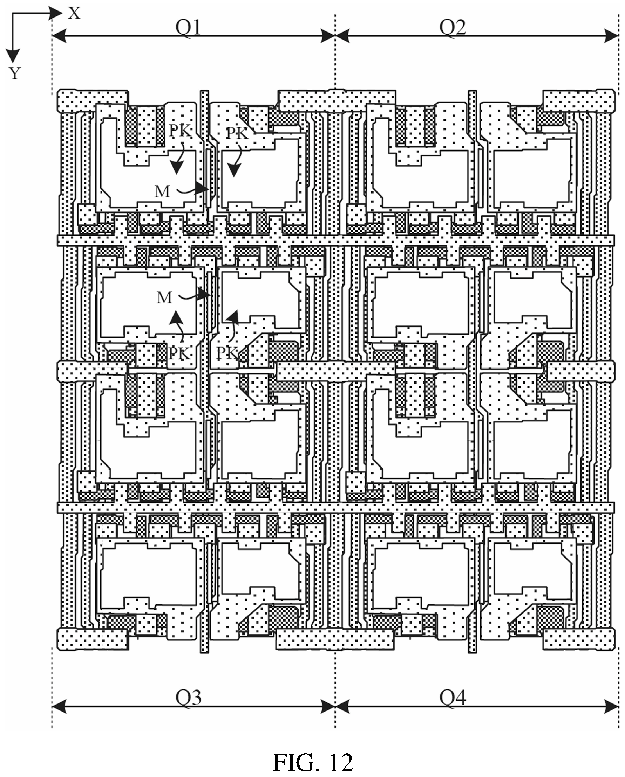

(18) A pixel definition layer is formed. In an exemplary implementation, forming the pattern of the pixel definition layer may include coating a pixel definition thin film on the base substrate on which the aforementioned patterns are formed, and patterning the pixel definition thin film by a patterning process to form the pixel definition layer that covers the fourth conductive layer, as shown in FIG. 12.

In an exemplary implementation, a pixel opening PK is formed on the pixel definition layer of each sub-pixel in each repetition unit, the pixel definition thin film within the pixel opening PK is removed to expose a portion of a surface of the first electrode 63, and an orthographic projection of the pixel opening PK on the base substrate is within a range of an orthographic projection of the first electrode 63 on the base substrate.

In an exemplary implementation, a shape of the pixel opening PK may be similar to a shape of the first electrode 63 on a plane parallel to the base substrate, and a shape of a cross-section of the pixel opening PK may be rectangular, trapezoidal or the like on a plane perpendicular to the base substrate.

In an exemplary implementation, a shape of the pixel opening may include any one or more of following: a triangle, a rectangle, a trapezoid, a parallel four-frame shape, a five-frame shape, a six-frame shape, a circle, and an ellipse.

In an exemplary implementation, shapes of pixel openings of four sub-pixels in a repetition unit may be the same or may be different. Areas of the pixel openings of the four sub-pixels may be the same or may be different.

In an exemplary implementation, shapes and areas of pixel openings of four sub-pixels in a repetition unit may be different to accommodate transmittances of filters of different sub-pixels, so that light emitting devices of the four sub-pixels can emit light with the same brightness at different currents, service lives of light emitting devices of four sub-pixels are optimized to the maximum extent, and a product life is guaranteed.

In an exemplary implementation, at least one partition groove M may also be provided on the pixel definition layer of each repetition unit, and the at least one partition groove M may have a shape of a strip with a main body portion extending along the second direction Y, and may be provided between adjacent pixel openings PK in the first direction X. For example, a partition groove M may be provided between a pixel opening PK of the first sub-pixel P1 and a pixel opening PK of the second sub-pixel P2. For another example, the partition groove M may be provided between a pixel opening PK of the third sub-pixel P3 and a pixel opening PK of the fourth sub-pixel P4. In an exemplary implementation, the partition groove M is configured to cut off an organic light emitting layer to be formed subsequently, block a lateral propagation path of hole-type carriers, eliminate a lateral leakage, and eliminate a lateral crosstalk of the sub-pixels.

In an exemplary implementation, the pixel definition layer may be made of polyimide, acrylic, or polyethylene terephthalate.

(19) Patterns of an organic emitting layer and a cathode are formed. In an exemplary implementation, forming the patterns of the organic emitting layer and the cathode may include first forming a pattern of an organic emitting layer, the organic emitting layer being connected to the first electrode 63 through the pixel opening PK; subsequently, forming a second electrode, and the second electrode being connected to the organic emitting layer. In an exemplary implementation, the second electrode may serve as a cathode of a light emitting device.

In an exemplary implementation, the organic emitting layer 93 may include an Emitting Layer (EML) and any one or more of following: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation, the organic emitting layer may be formed by evaporation using a fine metal mask (FMM) or an open mask, or through an inkjet process.

(20) A pattern of an encapsulation structure layer is formed. In an exemplary implementation, forming the pattern of the encapsulation structure layer may include first depositing a first inorganic thin film by using an open mask to form a first encapsulation layer; then, performing ink-jet printing an organic material on the first encapsulation layer through an ink-jet printing process, and forming a second encapsulation layer after curing; then, depositing a second inorganic thin film by using an open mask to form a third encapsulation layer, wherein the first encapsulation layer, the second encapsulation layer and the third encapsulation layer form the encapsulation structure layer. The first encapsulation layer and the third encapsulation layer may be made of any one or more of silicon oxide (SiOx), silicon nitride (SiNx), silicon carbide (SiC), silicon carbonitride (SiCN) and silicon nitride (SiON), and each may be in a single-layer structure, a multi-layer structure, or a composite layer structure. The second encapsulation layer may be made of a resin material, thereby forming a stacked structure of inorganic material/organic material/inorganic material, wherein the organic material layer is disposed between the two inorganic material layers, thus ensuring that external moisture cannot enter the light emitting structure layer.

So far, the manufacturing of the display substrate according to an exemplary embodiment of the present disclosure is completed. The display substrate may include a drive circuit layer provided on the base substrate, a light emitting structure layer provided on a side of the drive circuit layer away from the base substrate, and an encapsulation structure layer provided on a side of the light emitting structure layer away from the base substrate. In a direction perpendicular to the display substrate, the drive circuit layer may include a first conductive layer, a second conductive layer, a first insulation layer, a semiconductor layer, a second insulation layer, a third conductive layer, a third insulation layer and a planarization layer provided sequentially on the base substrate, the light emitting structure layer may include a first electrode, a pixel definition layer, an organic emitting layer and a second electrode, and the encapsulation structure layer may include a first encapsulation layer, a second encapsulation layer and a third encapsulation layer that are stacked.

In an exemplary implementation, for a display substrate including a color filter structure layer, after the third conductive layer is formed, a third insulation layer may be formed first, then a red color filter layer, a green color filter layer, and a blue color filter layer may be sequentially formed, and then a planarization layer may be formed, which is not limited here in the present disclosure.

In an exemplary implementation, the base substrate may be a flexible base substrate, or a rigid base substrate. The rigid base substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In an exemplary implementation, the flexible base substrate may include a first flexible material layer, a first inorganic material layer, a semiconductor layer, a second flexible material layer, and a second inorganic material layer that are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNₓ) or Silicon Oxide (SiOₓ), or the like, for improving a water and oxygen resistance capability of the base substrate, and a material of the semiconductor layer may be amorphous silicon (a-si).

In an exemplary implementation, the second conductive layer and the third conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The first insulation layer, the second insulation layer, and the second insulation layer may be made of any one or more of Silicon Oxide (SiOₓ), Silicon Nitride (SiNₓ), and Silicon Oxynitride (SiON), and may be in a single layer, a multi-layer, or a composite layer. The planarization layer may be made of an organic material, such as resin.

An embodiment of the present disclosure provides a display substrate with a bottom emission structure. By providing that a first electrode of a second transistor in a sub-pixel is at a position close to a first power supply line, two adjacent sub-pixels of two repetition units adjacent in the first direction share a power supply via connected to a gate metal layer and a second conductive layer, and two adjacent sub-pixels of two repetition units adjacent in the second direction share a power supply via connected to the gate metal layer and the second conductive layer, a quantity of vias is reduced, an area occupied by a pixel drive circuit can be effectively reduced, a pixel aperture ratio is increased, and a display resolution is improved. In addition, manufacturing process can be simplified by the reduced quantity of the vias, a production cost can be reduced, and a product yield can be improved.

By providing that second active layers in two adjacent sub-pixels of two repetition units adjacent in the second direction are interconnected to form an integral structure, and the two adjacent sub-pixels of the two repetition units adjacent in the second direction share an active via connected to the gate metal layer and the semiconductor layer according to an embodiment of the present disclosure, a quantity of switch vias is further reduced, the area occupied by pixel drive circuits can be effectively reduced, the pixel aperture ratio is increased, and the display resolution is improved.

By providing that power supply connection electrodes in two adjacent sub-pixels of two repetition units adjacent in the first direction are interconnected to form an integral structure and the two adjacent sub-pixels of two repetition units adjacent in the second direction share the power supply connection electrode according to an embodiment of the present disclosure, a quantity of connection electrodes is reduced, the area occupied by pixel drive circuits can be effectively reduced, the pixel aperture ratio is increased, and the display resolution is improved. In addition, manufacturing process can be simplified by the reduced quantity of the connection electrodes, the production cost can be reduced, and the product yield can be improved.

By providing a second active layer with a greater width and a second active layer with a smaller width are alternately provided in the first direction X and the second direction Y according to an embodiment of the present disclosure, not only requirements of a structure of a single scan signal line can be effectively matched, but also uniformity of a layout of a four-pixel drive circuit in a repetition unit can be effectively increased and uniformity of pixel openings of four sub-pixels in the repetition unit can be effectively increased.

The display substrate according to the embodiment of the present disclosure provides structures, such as a first power supply line, a data signal line, and a compensation signal line on the shield layer and on a side of the semiconductor layer close to the base substrate, and provides structures, such as a scan signal line and gate electrodes of multiple transistors on a GT layer and on a side of the semiconductor layer away from the base substrate, not only one conductive layer is reduced, but also a patterning process of switch vias and a patterning process of switch conductive layer are reduced, so that a manufacturing process of the drive structure layer requires only six patterning (MASK) processes. Compared with an existing manufacturing process that requires nine patterning processes, the display substrate according to the present disclosure reduces a quantity of patterning processes, a production efficiency is effectively improved, a production cost is effectively reduced, and a product yield is improved to the greatest extent.

The display substrate according to the embodiment of the present disclosure adopts a 3T1C pixel drive circuit using one scan signal line, in which the scan signal line is connected to a first transistor and a third transistor in the pixel drive circuit. By reducing a quantity of scan signal lines, a structure of the pixel drive circuit can be simplified, an area occupied by the pixel drive circuit can be reduced, and high-resolution display can be achieved. In addition, since one repetition unit only needs to be driven by one scan signal line, a quantity of the corresponding gate drive circuits (GOA) and clock signal lines (CLK) can be cut in doubles, an area occupied by the gate drive circuits and clock signal lines is effectively reduced, which is beneficial to achieving a narrow bezel, and improving product advantages.

The display substrate according to the embodiment of the present disclosure forms a transparent storage capacitor by a transparent conductive layer and a transparent semiconductor layer, so that light can be emitted through the transparent storage capacitor, and therefore the storage capacitor can be provided in a pixel opening, which can not only effectively increase a capacitance of the storage capacitor, but also can effectively increase pixel aperture ratio.

The display substrate according to the embodiment of the present disclosure adopt a square arrangement of sub-pixels and adopts a structure of first power supply lines with a non-mesh structure, the pixel aperture ratio is effectively increased, and a display effect is improved, which is more suitable for displaying of the display type.

The manufacturing process in the present disclosure may be compatible well with an existing manufacturing process, is simple in process implementation, is easy to implement, and has a high production efficiency, a low production cost, and a high yield.

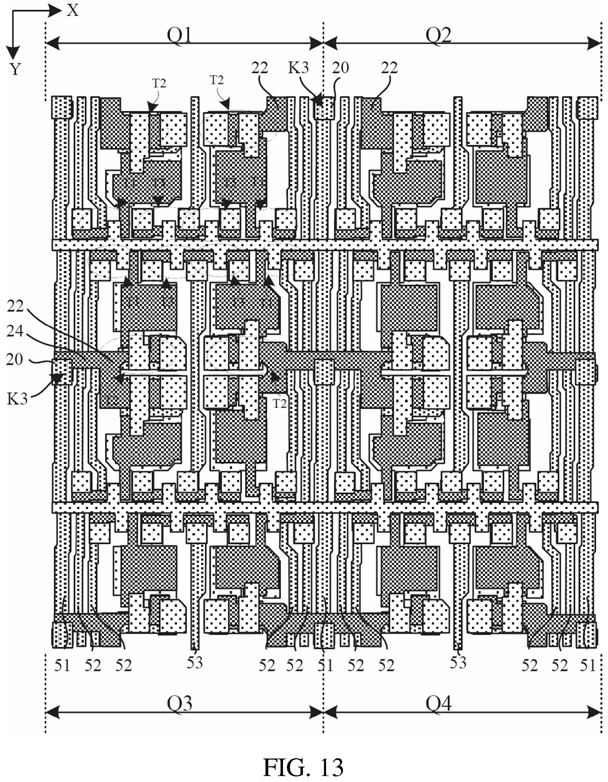

FIG. 13 is a schematic diagram of a structure of another display substrate according to an embodiment of the present disclosure, illustrating a structure of four repetition units (sixteen sub-pixels) in a bottom emission display substrate. In an exemplary implementation, a main body structure of the display substrate of this embodiment is substantially the same as a main body structure of a foregoing embodiment, except that the pixel drive circuit further includes an active connection electrode 24, and the power supply connection electrode 20 is simultaneously connected to the first power supply line 51 and the active connection electrode 24 through one switch via.

In an exemplary implementation, structures, such as a scan signal line 30, a first power supply line 51, a data signal line 52, a compensation signal line 53, a storage capacitor 60, a first transistor T1, a second transistor T2, and a third transistor T3 according to this embodiment are substantially the same as those of a foregoing embodiment, and will not be repeated herein.

In an exemplary implementation, the pixel drive circuit further includes an active connection electrode 24. The active connection electrode 24 may have a shape of a strip extending along the first direction X, a first end of the active connection electrode 24 is connected to a first region of the second active layer 22, and the first end of the active connection electrode 24 and the first region of the second active layer 22 are of an integral structure, and a second end of the active connection electrode 24 extends in a direction away from the second active layer 22 to an area where the first power supply line 51 is located.

In an exemplary implementation, the second active layer 22 and the active connection electrode 24 may be interconnected to form an integral structure.

In an exemplary implementation, an orthographic projection of the second end of the active connection electrode 24 on the base substrate is at least partially overlapped with an orthographic projection of the first power supply line 51 on the base substrate.

In an exemplary implementation, an orthographic projection of the active connection electrode 24 on the base substrate is at least partially overlapped with an orthographic projection of the data signal line 52 on the base substrate to form a structure in which the second active layer 22 spans the data signal line 52.

In an exemplary implementation, the power supply connection electrode 20 may have a shape of a block (for example, a rectangle), and the power supply connection electrode 20 is simultaneously connected to of the first power supply line 51 and the second end the active connection electrode 24 through a switch via K3.

In an exemplary implementation, the switch via K3 may include a shallow half hole and a deep half hole, the shallow half hole exposes a surface of the second end of the active connection electrode 24, the deep half hole exposes a surface of the first power supply line 51, and the shallow half hole may serve as an active via of the present disclosure, and the deep half hole may serve as a power supply via of the present disclosure.

In an exemplary implementation, two adjacent sub-pixels of two repetition units adjacent in the first direction X share a same switch via K3. For example, for a first repetition unit Q1 and a second repetition unit Q2 adjacent in the first direction X, the fourth sub-pixel P4 of the first repetition unit Q1 and the third sub-pixel P3 of the second repetition unit Q2 share a same switch via K3. For another example, for a third repetition unit Q3 and a fourth repetition unit Q4 adjacent in the first direction X, the fourth sub-pixel P4 of the third repetition unit Q3 and the third sub-pixel P3 of the fourth repetition unit Q4 share a same switch via K3.

In an exemplary implementation, two adjacent sub-pixels of two repetition units adjacent in the second direction Y share a same switch via K3. For example, for a first repetition unit Q1 and a third repetition unit Q3 adjacent in the second direction Y, the third sub-pixel P3 of the first repetition unit Q1 and the first sub-pixel P1 of the third repetition unit Q3 may share a same switch via K3, and the fourth sub-pixel P4 of the first repetition unit Q1 and the second sub-pixel P2 of the third repetition unit Q3 may share a same switch via K3. For another example, for a second repetition unit Q2 and a fourth repetition unit Q4 adjacent in the second direction Y, the third sub-pixel P3 of the second repetition unit Q2 and the first sub-pixel P1 of the fourth repetition unit Q4 may share a same switch via K3, and the fourth sub-pixel P4 of the second repetition unit Q2 and the second sub-pixel P2 of the fourth repetition unit Q4 may share a same switch via K3.

In an exemplary implementation, adjacent sub-pixels of the repetition units adjacent in the first direction X and the second direction Y share a same switch via K3, i.e., the four adjacent sub-pixels of the adjacent repetition units share the same switch via K3. For example, the fourth sub-pixel P4 of the first repetition unit Q1, the third sub-pixel P3 of the second repetition unit Q2, the second sub-pixel P2 of the third repetition unit Q3, and the first sub-pixel P1 of the fourth repetition unit Q4 may share the same switch via K3.

In an exemplary implementation, second ends of the active connection electrodes 24 in two adjacent sub-pixels of two repetition units adjacent in the first direction X may be connected to each other. Since the active connection electrode 24 of each sub-pixel is connected to the first region of the second active layer 22, the first regions of the second active layers 22 in the two adjacent sub-pixels of the two repetition units adjacent in the first direction X are connected to each other through the active connection electrode 24. For example, for a first repetition unit Q1 and a second repetition unit Q2 adjacent in the first direction X, the first region of the second active layer 22 in the fourth sub-pixel P4 of the first repetition unit Q1 and the first region of the second active layer 22 in the third sub-pixel P3 of the second repetition unit Q2 are connected to each other through the active connection electrode 24. For another example, for a third repetition unit Q3 and a fourth repetition unit Q4 adjacent in the first direction X, the first region of the second active layer 22 in the fourth sub-pixel P4 of the third repetition unit Q3 and the first region of the second active layer 22 in the third sub-pixel P3 of the fourth repetition unit Q4 are connected to each other through the active connection electrode 24.

In an exemplary implementation, the active connection electrodes 24 in two adjacent sub-pixels of two repetition units adjacent in the first direction X are interconnected to form an integral structure.

In an exemplary implementation, two adjacent sub-pixels of two repetition units adjacent in the second direction Y may share a same active connection electrode 24. For example, for a first repetition unit Q1 and a third repetition unit Q3 adjacent in the second direction Y, the third sub-pixel P3 of the first repetition unit Q1 and the first sub-pixel P1 of the third repetition unit Q3 may share a same active connection electrode 24, and the fourth sub-pixel P4 of the first repetition unit Q1 and the second sub-pixel P2 of the third repetition unit Q3 may share a same active connection electrode 24. For another example, for a second repetition unit Q2 and a fourth repetition unit Q4 adjacent in the second direction Y, the third sub-pixel P3 of the second repetition unit Q2 and the first sub-pixel P1 of the fourth repetition unit Q4 may share a same active connection electrode 24, and the fourth sub-pixel P4 of the second repetition unit Q2 and the second sub-pixel P2 of the fourth repetition unit Q4 may share a same active connection electrode 24.

In an exemplary implementation, first regions of the second active layers 22 in adjacent sub-pixels of the repetition units adjacent in the first direction X and the second direction Y may be connected to each other through the active connection electrode 24.

In an exemplary implementation, two adjacent sub-pixels of two repetition units adjacent in the first direction X share a same power supply connection electrode 20. For example, for a first repetition unit Q1 and a second repetition unit Q2 adjacent in the first direction X, the fourth sub-pixel P4 of the first repetition unit Q1 and the third sub-pixel P3 of the second repetition unit Q2 share a same power supply connection electrode 20. For another example, for a third repetition unit Q3 and a fourth repetition unit Q4 adjacent in the first direction X, the fourth sub-pixel P4 of the third repetition unit Q3 and the third sub-pixel P3 of the fourth repetition unit Q4 share a same power supply connection electrode 20.

In an exemplary implementation, two adjacent sub-pixels of two repetition units adjacent in the second direction Y share a same power supply connection electrode 20. For example, for a first repetition unit Q1 and a third repetition unit Q3 adjacent in the second direction Y, the third sub-pixel P3 of the first repetition unit Q1 and the first sub-pixel P1 of the third repetition unit Q3 may share a same power supply connection electrode 20, and the fourth sub-pixel P4 of the first repetition unit Q1 and the second sub-pixel P2 of the third repetition unit Q3 may share a same power supply connection electrode 20. For another example, for a second repetition unit Q2 and a fourth repetition unit Q4 adjacent in the second direction Y, the third sub-pixel P3 of the second repetition unit Q2 and the first sub-pixel P1 of the fourth repetition unit Q4 may share a same power supply connection electrode 20, and the fourth sub-pixel P4 of the second repetition unit Q2 and the second sub-pixel P2 of the fourth repetition unit Q4 may share a same power supply connection electrode 20.

In an exemplary implementation, adjacent sub-pixels of the repetition units adjacent in the first direction X and the second direction Y share the same power supply connection electrode 20, i.e., the four adjacent sub-pixels of the adjacent repetition units share the same power supply connection electrode 20. For example, the fourth sub-pixel P4 of the first repetition unit Q1, the third sub-pixel P3 of the second repetition unit Q2, the second sub-pixel P2 of the third repetition unit Q3, and the first sub-pixel P1 of the fourth repetition unit Q4 share the same power supply connection electrode 20.

In an exemplary implementation, the process of manufacturing the display substrate according to the present embodiment may include the following operations.

(21) A pattern of a first conductive layer is formed. A processing process and a structure of the formed first conductive layer are substantially the same as those in the step (11) of the foregoing embodiment.

(22) A pattern of a second conductive layer is formed. A processing process and a structure of the formed second conductive layer are substantially the same as those in the step (12) of the foregoing embodiment.

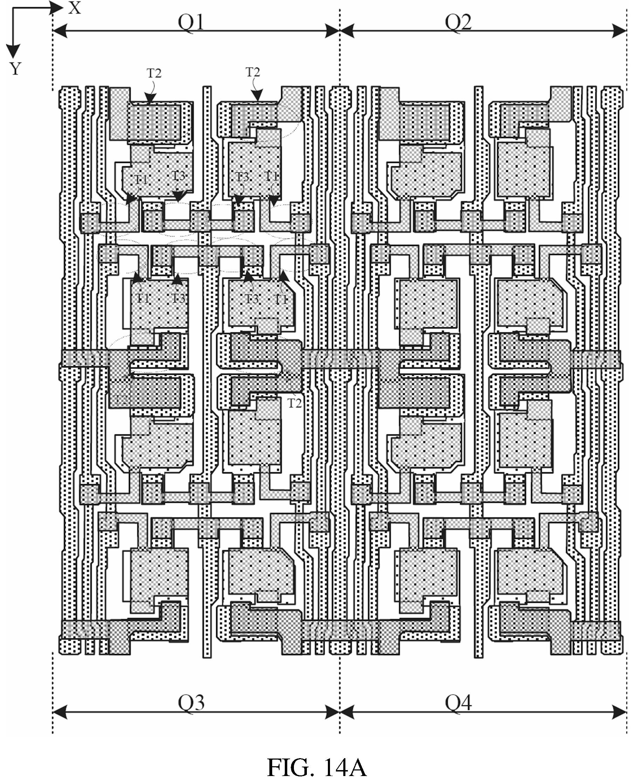

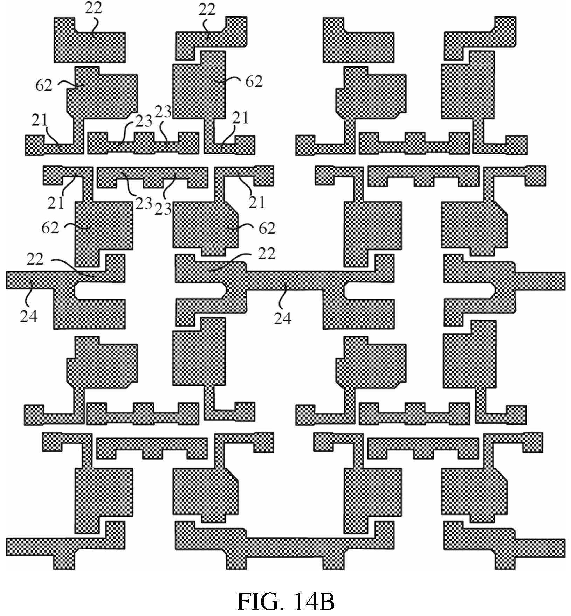

(23) A pattern of a semiconductor layer is formed. A processing process and a structure of the formed semiconductor layer are substantially the same as those in the step (13) of a foregoing embodiment, except that the semiconductor layer further includes an active connection electrode 24, as shown in FIG. 14A and FIG. 14B, and FIG. 14B is a schematic diagram of the semiconductor layer in FIG. 14A.

In an exemplary implementation, the semiconductor layer of each sub-pixel in each repetition unit may at least include a first active layer 21, a second active layer 22, a third active layer 23, and a second plate 62 of a storage capacitor, structures of which are substantially the same as structures in the foregoing embodiment.

In an exemplary implementation, the semiconductor layer of each sub-pixel may further include an active connection electrode 24, the active connection electrode 24 may have a shape of a strip extending along the first direction X, a first end of the active connection electrode 24 is connected to a first region of the second active layer 22, the first end of the active connection electrode 24 and the first region of the second active layer 22 are of an integral structure, a second end of the active connection electrode 24 extends in a direction away from the second active layer 22 to an area where the first power supply line 51 is located, and the second end of the active connection electrode 24 is configured to be connected to the first power supply line 51 through a power supply connection electrode to be formed subsequently.

In an exemplary implementation, the second active layer 22 and the active connection electrode 24 may be interconnected to form an integral structure.

In an exemplary implementation, an orthographic projection of the second end of the active connection electrode 24 on the base substrate is at least partially overlapped with an orthographic projection of the first power supply line 51 on the base substrate.

In an exemplary implementation, an orthographic projection of the active connection electrode 24 on the base substrate is at least partially overlapped with an orthographic projection of a data signal line 52 on the base substrate, forming a structure in which the second active layer 22 spans the data signal line 52.

In an exemplary implementation, the second active layers 22 in two adjacent sub-pixels of two repetition units adjacent in the second direction Y may be interconnected to form an integral structure, so that two adjacent sub-pixels of two repetition units adjacent in the second direction Y may share a same active connection electrode 24. For example, for a first repetition unit Q1 and a third repetition unit Q3 adjacent in the second direction Y, the third sub-pixel P3 of the first repetition unit Q1 and the first sub-pixel P1 of the third repetition unit Q3 may share a same active connection electrode 24, and the fourth sub-pixel P4 of the first repetition unit Q1 and the second sub-pixel P2 of the third repetition unit Q3 may share a same active connection electrode 24. For another example, for a second repetition unit Q2 and a fourth repetition unit Q4 adjacent in the second direction Y, the third sub-pixel P3 of the second repetition unit Q2 and the first sub-pixel P1 of the fourth repetition unit Q4 may share a same active connection electrode 24, and the fourth sub-pixel P4 of the second repetition unit Q2 and the second sub-pixel P2 of the fourth repetition unit Q4 may share a same active connection electrode 24.

In an exemplary implementation, the active connection electrodes 24 in two adjacent sub-pixels of two repetition units adjacent in the first direction X may be connected to each other. Since the active connection electrode 24 of each sub-pixel is connected to the first region of the second active layer 22, the first regions of the second active layers 22 in two adjacent sub-pixels of two repetition units adjacent in the first direction X are connected to each other through an active connection electrode 24. For example, for a first repetition unit Q1 and a second repetition unit Q2 adjacent in the first direction X, the first region of the second active layer 22 in the fourth sub-pixel P4 of the first repetition unit Q1 and the first region of the second active layer 22 in the third sub-pixel P3 of the second repetition unit Q2 are connected to each other through the active connection electrode 24. For another example, for a third repetition unit Q3 and a fourth repetition unit Q4 adjacent in the first direction X, the first region of the second active layer 22 in the fourth sub-pixel P4 of the third repetition unit Q3 and the first region of the second active layer 22 in the third sub-pixel P3 of the fourth repetition unit Q4 are connected to each other through an active connection electrode 24.

In an exemplary implementation, the active connection electrodes 24 in two adjacent sub-pixels of two repetition units adjacent in the first direction X are interconnected to form an integral structure.

In an exemplary implementation, the first regions of the second active layers 22 in adjacent sub-pixels of the repetition units adjacent in the first direction X and the second direction Y may be connected to each other through an active connection electrode 24. For example, the first region of the second active layer 22 in the fourth sub-pixel P4 of the first repetition unit Q1, the first region of the second active layer 22 in the third sub-pixel P3 of the second repetition unit Q2, the first region of the second active layer 22 in the second sub-pixel P2 of the third repetition unit Q3 and the first region of the second active layer 22 in the first sub-pixel P1 of the fourth repetition unit Q4 may be connected to each other through the active connection electrode 24. By providing the second transistors in the four adjacent sub-pixels of the adjacent repetition units share the first regions of the second active layers according to the present disclosure, not only a quantity of vias can be effectively reduced, an area occupied by the pixel drive circuits can be reduced, a pixel aperture ratio can be increased, and a display resolution can be improved, but also manufacturing process can be simplified by the reduced quantity of the vias, a production cost can be reduced, and a product yield can be improved.

In an exemplary implementation, widths of second active layers in adjacent sub-pixels in the first direction X are different, and widths of second active layers in adjacent sub-pixels in the second direction Y are different.

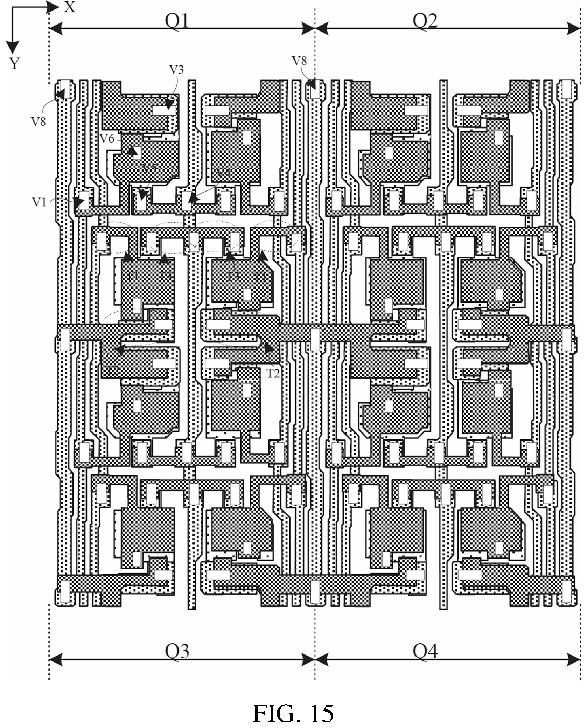

(24) A pattern of a second insulation layer is formed. A processing process and a structure of the formed second insulation layer are substantially the same as those in the step (14) of the foregoing embodiment, except that an eighth via V8 is a via having a switch structure, as shown in FIG. 15.

In an exemplary implementation, multiple vias are provided on the second insulation layer, and the multiple vias of each sub-pixel in each repetition unit at least include a first via V1, a third via V3 to a sixth via V6, and a structure of the above vias is substantially the same as that of the a foregoing embodiment.

In an exemplary implementation, an orthographic projection of the eighth via V8 on the base substrate is within a range of an orthographic projection of the second end of the active connection electrode 24 and the first power supply line 51 on the base substrate. The eighth via V8, as the switch via of the present disclosure, includes a shallow half hole and a deep half hole, the second insulation layer in the shallow half hole is etched away to expose a surface of the second end of the active connection electrode 24, and the first insulation layer and the second insulation layer in the deep half hole are etched away to expose a surface of the first power supply line 51, so that the via having the switch structure composed of the two half holes simultaneously exposes the second end of the active connection electrode 24 and the first power supply line 51, and the eighth via V8 is configured such that the power supply connection electrode to be formed subsequently is connected to the second end of the active connection electrode 24 and the first power supply line 51 through the eighth via V8. In an exemplary implementation, the eighth via V8 serves as the switch via of the present disclosure, the shallow half hole may serve as an active via of the present disclosure, and the deep half hole may serve as a power supply via of the present disclosure.

In an exemplary implementation, since the active connection electrodes 24 in two adjacent sub-pixels of two repetition units adjacent in the first direction X are interconnected to form an integral structure, and two adjacent sub-pixels of two repetition units adjacent in the first direction X share the same eighth via V8. For example, for a first repetition unit Q1 and a second repetition unit Q2 adjacent in the first direction X, the fourth sub-pixel P4 of the first repetition unit Q1 and the third sub-pixel P3 of the second repetition unit Q2 share a same eighth via V8. For another example, for a third repetition unit Q3 and a fourth repetition unit Q4 adjacent in the first direction X, the fourth sub-pixel P4 of the third repetition unit Q3 and the third sub-pixel P3 of the fourth repetition unit Q4 share a same eighth via V8. By providing that two adjacent sub-pixels of two repetition units adjacent in the first direction X share the same eighth via V8 according to the present disclosure, not only the quantity of vias can be effectively reduced, the area occupied by the pixel drive circuit can be reduced, the pixel aperture ratio can be increased, and the display resolution can be improved, but also manufacturing process can be simplified by the reduced quantity of the vias, the production cost can be reduced, and the product yield can be improved.

In an exemplary implementation, since two adjacent sub-pixels of two repetition units adjacent in the second direction Y may share a same active connection electrode 24, two adjacent sub-pixels of two repetition units adjacent in the second direction Y share a same eighth via V8. For example, for a first repetition unit Q1 and a third repetition unit Q3 adjacent in the second direction Y, the third sub-pixel P3 of the first repetition unit Q1 and the first sub-pixel P1 of the third repetition unit Q3 may share a same eighth via V8, and the fourth sub-pixel P4 of the first repetition unit Q1 and the second sub-pixel P2 of the third repetition unit Q3 may share a same eighth via V8. For another example, for a second repetition unit Q2 and a fourth repetition unit Q4 adjacent in the second direction Y, the third sub-pixel P3 of the second repetition unit Q2 and the first sub-pixel P1 of the fourth repetition unit Q4 may share a same eighth via V8, and the fourth sub-pixel P4 of the second repetition unit Q2 and the second sub-pixel P2 of the fourth repetition unit Q4 may share a same eighth via V8. By providing that two adjacent sub-pixels of two repetition units adjacent in the second direction Y share the same eighth via V8 according to the present disclosure, not only the quantity of vias can be effectively reduced, the area occupied by the pixel drive circuits can be reduced, the pixel aperture ratio can be increased, and the display resolution can be improved, but also manufacturing process can be simplified by the reduced quantity of the vias, the production cost can be reduced, and the product yield can be improved.

In an exemplary implementation, adjacent sub-pixels of the repetition units adjacent in the first direction X and the second direction Y share the same switch via K3, i.e., the four adjacent sub-pixels of the adjacent repetition units share the same eighth via V8. For example, the fourth sub-pixel P4 of the first repetition unit Q1, the third sub-pixel P3 of the second repetition unit Q2, the second sub-pixel P2 of the third repetition unit Q3, and the first sub-pixel P1 of the fourth repetition unit Q4 may share the same eighth via V8.

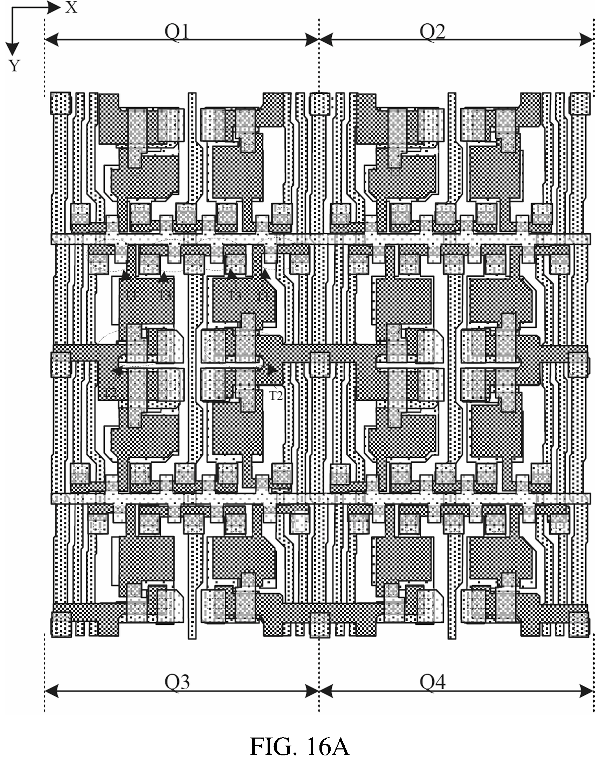

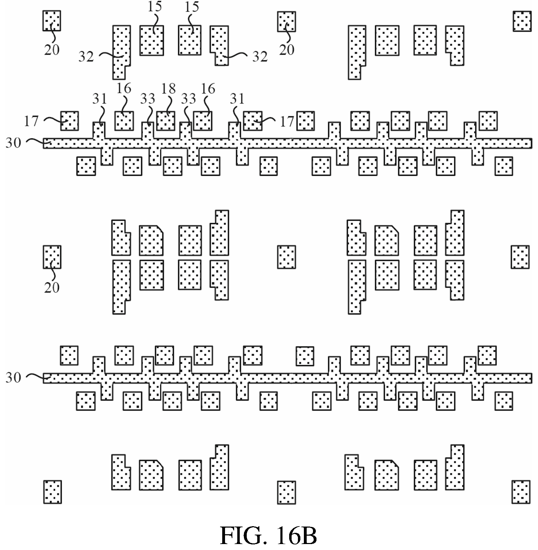

(25) A pattern of a third conductive layer is formed. A processing process and a structure of the formed third conductive layer are substantially the same as those in the step (15) of the foregoing embodiment, except that the power supply connection electrode 20 is simultaneously connected to the second end of the active connection electrode 24 and the first power supply line 51 through the eighth via V8 of the switch structure, as shown in FIG. 16A and FIG. 16B, and FIG. 16B is a schematic diagram of the third conductive layer in FIG. 16A.

In an exemplary implementation, the third conductive layer of each sub-pixel in each repetition unit may at least include a fifth connection electrode 15, a sixth connection electrode 16, a seventh connection electrode 17, an eighth connection electrode 18, a power supply connection electrode 20, a scan signal line 30, a first gate electrode 31, a second gate electrode 32, and a third gate electrode 33, structures of which are substantially the same as those in the foregoing embodiment except for the power supply connection electrode 20.

In an exemplary implementation, the power supply connection electrode 20 may have a shape of a block (for example, a rectangle), and the power supply connection electrode 20 is simultaneously connected to the second end of the active connection electrode 24 and the first power supply line 51 through the eighth via V8 of the switch structure. Since the active connection electrode 24 is connected to the first region of the second active layer, writing of the first power supply signal into the first electrode of the second transistor T2 by the first power supply line 51 is achieved.

In an exemplary implementation, since two adjacent sub-pixels of two repetition units adjacent in the first direction X share a same eighth via V8, two adjacent sub-pixels of two repetition units adjacent in the first direction X share a same power supply connection electrode 20. For example, for a first repetition unit Q1 and a second repetition unit Q2 adjacent in the first direction X, the fourth sub-pixel P4 of the first repetition unit Q1 and the third sub-pixel P3 of the second repetition unit Q2 share a same power supply connection electrode 20. For another example, for a third repetition unit Q3 and a fourth repetition unit Q4 adjacent in the first direction X, the fourth sub-pixel P4 of the third repetition unit Q3 and the third sub-pixel P3 of the fourth repetition unit Q4 share a same power supply connection electrode 20. By providing that two adjacent sub-pixels of two repetition units adjacent in the first direction X share the same power supply connection electrode according to the present disclosure, not only a quantity of connection electrodes can be effectively reduced, the area occupied by the pixel drive circuits can be reduced, the pixel aperture ratio can be increased, and the display resolution can be improved, but also manufacturing process can be simplified by the reduced quantity of the connection electrodes, the production cost can be reduced, and the product yield can be improved.

In an exemplary implementation, since two adjacent sub-pixels of two repetition units adjacent in the second direction Y share a same eighth via V8, two adjacent sub-pixels of two repetition units adjacent in the second direction Y share a same power supply connection electrode 20. For example, for a first repetition unit Q1 and a third repetition unit Q3 adjacent in the second direction Y, the third sub-pixel P3 of the first repetition unit Q1 and the first sub-pixel P1 of the third repetition unit Q3 may share a same power supply connection electrode 20, and the fourth sub-pixel P4 of the first repetition unit Q1 and the second sub-pixel P2 of the third repetition unit Q3 may share a same power supply connection electrode 20. For another example, for a second repetition unit Q2 and a fourth repetition unit Q4 adjacent in the second direction Y, the third sub-pixel P3 of the second repetition unit Q2 and the first sub-pixel P1 of the fourth repetition unit Q4 may share a same power supply connection electrode 20, and the fourth sub-pixel P4 of the second repetition unit Q2 and the second sub-pixel P2 of the fourth repetition unit Q4 may share a same power supply connection electrode 20. By providing that two adjacent sub-pixels of two repetition units adjacent in the second direction Y share the same power supply connection electrode according to the present disclosure, not only a quantity of connection electrodes can be effectively reduced, the area occupied by the pixel drive circuits can be reduced, the pixel aperture ratio can be increased, and the display resolution can be improved, but also manufacturing process can be simplified by the reduced quantity of the connection electrodes, the production cost can be reduced, and the product yield can be improved.

In an exemplary implementation, adjacent sub-pixels of the repetition units adjacent in the first direction X and the second direction Y share the same power supply connection electrode 20, i.e., the four adjacent sub-pixels of the adjacent repetition units share the same power supply connection electrode 20. For example, the fourth sub-pixel P4 of the first repetition unit Q1, the third sub-pixel P3 of the second repetition unit Q2, the second sub-pixel P2 of the third repetition unit Q3, and the first sub-pixel P1 of the fourth repetition unit Q4 share the same power supply connection electrode 20. By providing that the four adjacent sub-pixels of the adjacent repetition units share the same power supply connection electrode 20 according to the present disclosure, not only the quantity of connection electrodes can be effectively reduced, the area occupied by the pixel drive circuits can be reduced, the pixel aperture ratio can be increased, and the display resolution can be improved, but also manufacturing process can be simplified by the reduced quantity of the connection electrodes, the production cost can be reduced, and the product yield can be improved.

**In** an exemplary implementation, a processing process and a formed structure of a third insulation layer, a planarization layer, a fourth conductive layer, a pixel definition layer, an organic emitting layer, a cathode and an encapsulation structure layer that are to be formed subsequently are substantially the same as those of the foregoing embodiment, which will not be repeated herein.

An embodiment of the present disclosure provides a display substrate with a bottom emission structure. By providing active connection electrodes, adjacent sub-pixels in repetition units adjacent in the first direction and the second direction share the switch via and a connection electrode that connects a gate metal layer to a semiconductor layer and a shield layer, quantities of switch vias and connection electrodes are effectively reduced, an area occupied by the pixel drive circuit can be effectively reduced, pixel aperture ratio can be increased, and display resolution can be improved. In addition, manufacturing process can be simplified by reduction of the switch vias and the connection electrodes, the production cost can be reduced, and the product yield can be improved.

The display substrate of the embodiment of the present disclosure also has the technical effects of reducing a quantity of patterning processes, reducing a quantity of scan signal lines, increasing pixel aperture ratio, and the like.

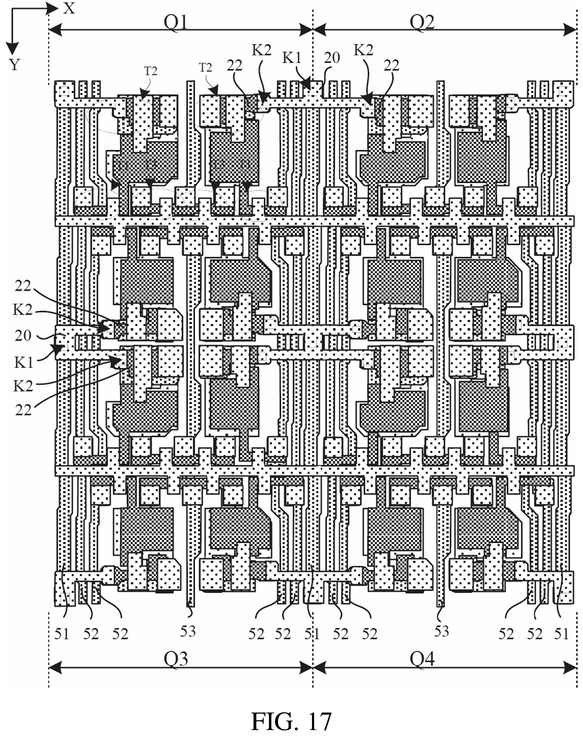

FIG. 17 is a schematic diagram of a structure of another display substrate according to an embodiment of the present disclosure, illustrating a structure of four repetition units (sixteen sub-pixels) in a bottom emission display substrate. In an exemplary implementation, a main body structure of the display substrate of this embodiment is substantially the same as a main body structure of the foregoing embodiment, except that first regions of second active layers 22 of two adjacent sub-pixels in two adjacent repetition units adjacent in the second direction Y are not connected to each other, and first ends of power supply connection electrodes 20 of two adjacent sub-pixels in two repetition units adjacent in the first direction X and the second direction Y are connected to each other.

In an exemplary implementation, structures, such as a scan signal line 30, a first power supply line 51, a data signal line 52, a compensation signal line 53, a storage capacitor 60, a first transistor T1, a second transistor T2, and a third transistor T3 according to this embodiment are substantially the same as those of the foregoing embodiment, which will not be repeated herein.

In an exemplary implementation, in at least one repetition unit, first regions of second active layers 22 in two adjacent sub-pixels of two repetition units adjacent in the second direction Y are not connected to each other, and the first power supply line 51 is connected to first region of second active layer 22 in each sub-pixel through a power supply connection electrode 20.

In an exemplary implementation, the power supply connection electrode 20 may have a shape of a strip extending along the first direction X, a first end of the power supply connection electrode 20 is connected to the first power supply line 51 through a power supply via K1, and a second end of the power supply connection electrode 20 is connected to the first region of second active layer 22 through an active via K2.

In an exemplary implementation, two adjacent sub-pixels of two repetition units adjacent in the first direction X share a same power supply via K1, and two adjacent sub-pixels of two repetition units adjacent in the second direction Y share a same power supply via K1.

In an exemplary implementation, the four adjacent sub-pixels of the repetition units adjacent in the first direction X and the second direction Y share the same power supply via K1. For example, the fourth sub-pixel P4 of the first repetition unit Q1, the third sub-pixel P3 of the second repetition unit Q2, the second sub-pixel P2 of the third repetition unit Q3, and the first sub-pixel P1 of the fourth repetition unit Q4 share the same power supply via K1.

In an exemplary implementation, first ends of power supply connection electrodes 20 in two adjacent sub-pixels of two repetition units adjacent in the first direction X are connected to each other. For example, first ends of two power supply connection electrodes 20 in the second sub-pixel P2 of the first repetition unit Q1 and the first sub-pixel P1 of the second repetition unit Q2 are connected to each other. For another example, first ends of the two power supply connection electrodes 20 in the fourth sub-pixel P4 of the first repetition unit Q1 and the third sub-pixel P3 of the second repetition unit Q2 are connected to each other.

In an exemplary implementation, the power supply connection electrodes 20 in two adjacent sub-pixels of two repetition units adjacent in the first direction X are interconnected to form an integral structure.

In an exemplary implementation, first ends of the power supply connection electrodes 20 in two adjacent sub-pixels of two repetition units adjacent in the second direction Y are connected to each other. For example, first ends of the power supply connection electrodes 20 in the third sub-pixel P3 of the first repetition unit Q1 and the first sub-pixel P1 of the third repetition unit Q3 are connected to each other. For another example, first ends of the power supply connection electrodes 20 in the fourth sub-pixel P4 of the first repetition unit Q1 and the second sub-pixel P2 of the third repetition unit Q2 are connected to each other.

In an exemplary implementation, the power supply connection electrodes 20 in two adjacent sub-pixels of two repetition units adjacent in the second direction Y are interconnected to form an integral structure.

In an exemplary implementation, the power supply connection electrodes 20 in adjacent sub-pixels of the repetition units adjacent in the first direction X and the second direction Y are interconnected to form an integral structure, i.e., the power supply connection electrodes 20 in the four adjacent sub-pixels of the adjacent repetition units are interconnected to form an integral structure. For example, the four power supply connection electrodes 20 in the fourth sub-pixel P4 of the first repetition unit Q1, the third sub-pixel P3 of the second repetition unit Q2, the second sub-pixel P2 of the third repetition unit Q3, and the first sub-pixel P1 of the fourth repetition unit Q4 are interconnected to form an integral structure.

In an exemplary implementation, the process of manufacturing the display substrate according to this embodiment may include the following operations.

(31) A pattern of a first conductive layer is formed. A processing process and a structure of the formed first conductive layer are substantially the same as those in the step (11) of the foregoing embodiment.

(32) A pattern of a second conductive layer is formed. A processing process and a structure of the formed second conductive layer are substantially the same as those in the step (12) of the foregoing embodiment.

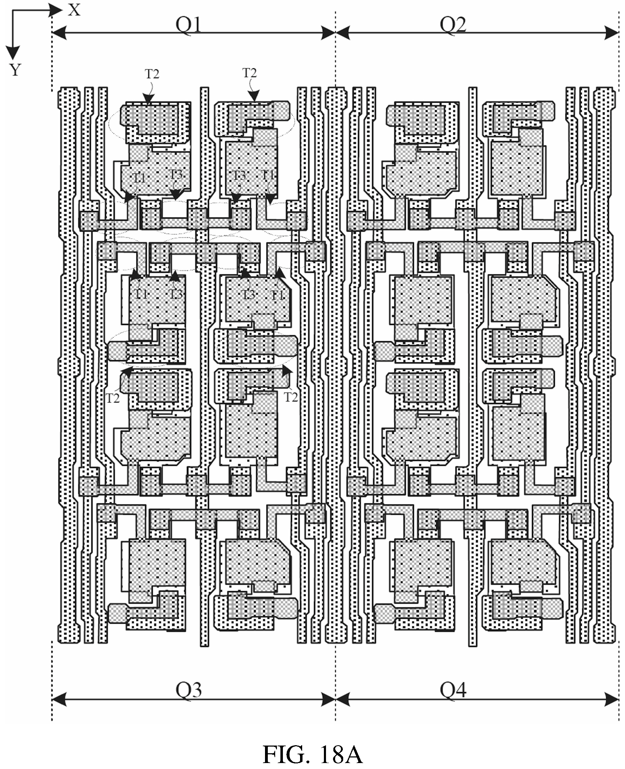

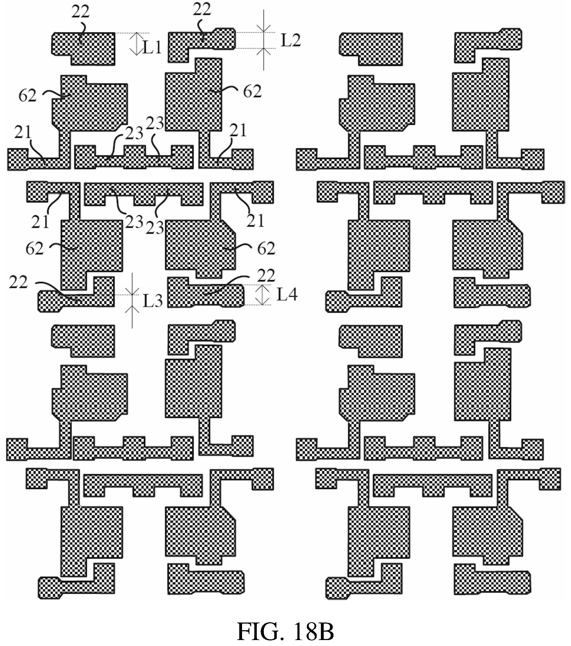

(33) A pattern of a semiconductor layer is formed. A processing process and a structure of the formed semiconductor layer are substantially the same as those in the step (13) of a foregoing embodiment, except that a second active layer 22 of each sub-pixel is provided separately, i.e., first regions of the second active layers 22 of adjacent sub-pixels are not connected to each other, as shown in FIG. 18A and FIG. 18B, and FIG. 18B is a schematic diagram of the semiconductor layer in FIG. 18A.

In an exemplary implementation, an orthographic projection of the second region and the channel region of the second active layer 22 of each sub-pixel on the base substrate is at least partially overlapped with an orthographic projection of the third connection electrode 13 on the base substrate, so that the third connection electrode 13 which serves as a shield layer can shield the channel region of the second transistor T2, avoid an influence of light on the channel, and ensure the electrical performance of the second transistor T2.

In an exemplary implementation, the first region of the second active layer 22 in each sub-pixel is provided separately, i.e., first regions of the second active layers 22 of adjacent sub-pixels are not connected to each other. In at least one sub-pixel, a distance between the first region of the second active layer 22 and the first power supply line 51 may be less than a distance between the second region of the second active layer 22 and the first power supply line 51, i.e., the first region of the second active layer 22 is closer to the first power supply line 51 than the second region of the second active layer 22.

In an exemplary implementation, widths of the second active layers in adjacent sub-pixels are different in the first direction X, and widths of the second active layers in adjacent sub-pixels are different in the second direction Y. In the first direction X, multiple second active layers with greater widths and multiple second active layers with smaller widths are alternately provided, and in the second direction Y, multiple second active layers with greater widths and multiple second active layers with smaller widths are alternately provided.

In an exemplary implementation, a first sub-pixel P1 and a second sub-pixel P2 are alternately provided in the first direction X, and a first width L1 of the second active layer 22 in the first sub-pixel P1 may be greater than a second width L2 of the second active layer 22 in the second sub-pixel P2. A third sub-pixel P3 and a fourth sub-pixel P4 are alternately provided in the first direction X, and a third width L3 of the second active layer 22 in the third sub-pixel P3 may be less than a fourth width L4 of the second active layer 22 in the fourth sub-pixel P4.

In an exemplary implementation, a first sub-pixel P1 and a third sub-pixel P3 are alternately provided in the second direction Y, and the first width L1 of the second active layer 22 in the first sub-pixel P1 may be greater than the third width L3 of the second active layer 22 in the third sub-pixel P3. The second sub-pixel P2 and the fourth sub-pixel P4 are alternately provided in the second direction Y, and the second width L2 of the second active layer 22 in the second sub-pixel P2 may be less than the fourth width L4 of the second active layer 22 in the fourth sub-pixel P4.

In an exemplary implementation, in at least one repetition unit, widths of the second active layers 22 of the four sub-pixels may be different. For example, the first width L1 of the second active layer 22 in the first sub-pixel P1 may be greater than the fourth width L4 of the second active layer 22 in the fourth sub-pixel P4. For another example, the second width L2 of the second active layer 22 in the second sub-pixel P2 may be greater than the third width L3 of the second active layer 22 in the third sub-pixel P3.

In an exemplary implementation, in an exemplary implementation, by providing that a second active layer with a greater width and a second active layer with a smaller width are alternately provided in the first direction X and the second direction Y according to the present disclosure, not only requirements of a structure of a single scan signal line can be effectively matched, but also uniformity of a layout of a four-pixel drive circuit in a repetition unit can be effectively increased and uniformity of pixel openings of four sub-pixels in a repetition unit can be effectively increased.

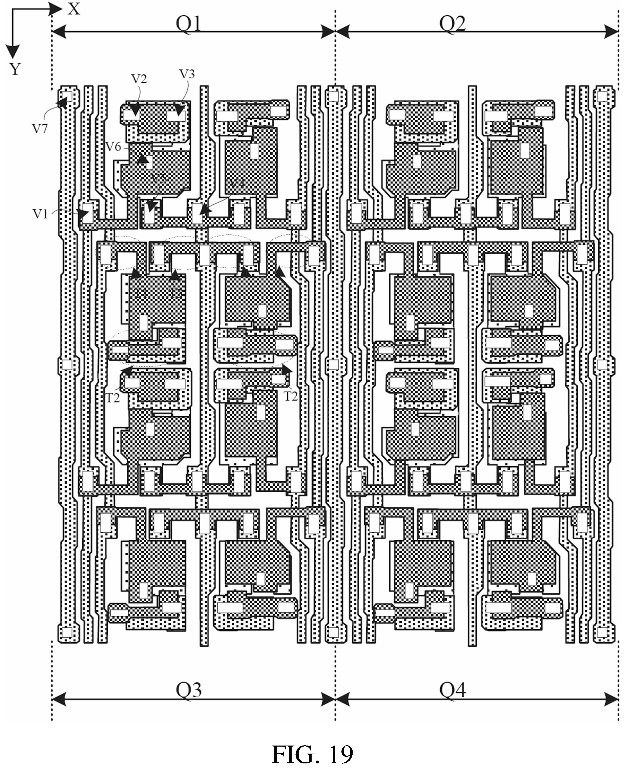

(34) A pattern of a second insulation layer is formed. A processing process and a structure of the formed second insulation layer are substantially the same as those in the step (14) of the foregoing embodiment, except that a second via V2 of each sub-pixel is provided separately, i.e., adjacent sub-pixels do not share the second via V2, as shown in FIG. 19.

In an exemplary implementation, multiple vias are provided on the second insulation layer, and the multiple vias of each sub-pixel in each repetition unit at least include a first via V1 to a seventh via V7, and a structure of the above vias is substantially the same as that of a foregoing embodiment.

In an exemplary implementation, two adjacent sub-pixels of two repetition units adjacent in the first direction X share a same seventh via V7, and two adjacent sub-pixels of two repetition units adjacent in the second direction Y share a same seventh via V7.

In an exemplary implementation, adjacent sub-pixels in repetition units adjacent in the first direction X and the second direction Y share the same seventh via V7, i.e., the four adjacent sub-pixels of the adjacent repetition units share the same seventh via V7.

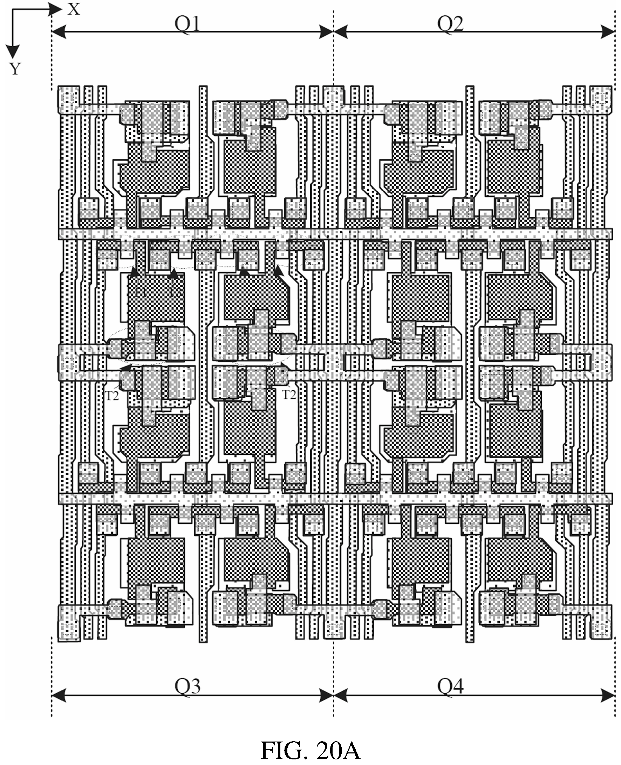

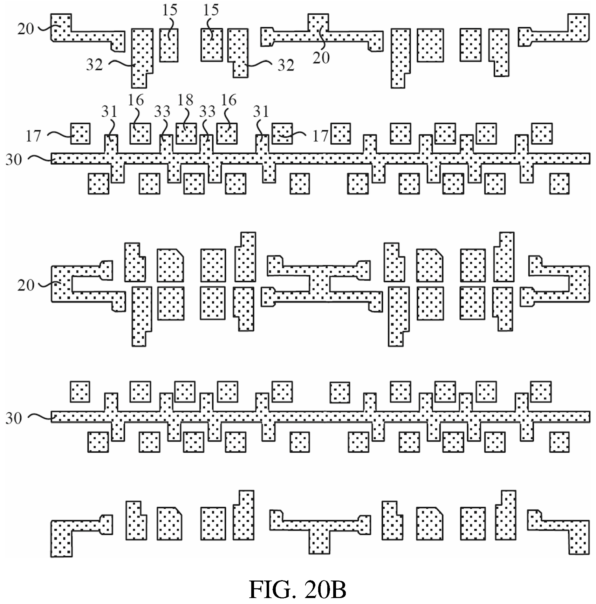

(35) A pattern of a third conductive layer is formed. A processing process and a structure of the formed third conductive layer are substantially the same as those in the step (15) of the foregoing embodiment, except that the power supply connection electrodes 20 are simultaneously connected to the first regions of the second active layers 22 of two sub-pixels through the second via V2 of the two sub-pixels, as shown in FIG. 20A and FIG. 20B, and FIG. 20B is a schematic diagram of the third conductive layer in FIG. 20A.

In an exemplary implementation, the third conductive layer of each sub-pixel in each repetition unit may at least include a fifth connection electrode 15, a sixth connection electrode 16, a seventh connection electrode 17, an eighth connection electrode 18, a power supply connection electrode 20, a scan signal line 30, a first gate electrode 31, a second gate electrode 32, and a third gate electrode 33, structures of which are substantially the same as those in the foregoing embodiment except for a power supply connection electrode 20.

In an exemplary implementation, the power supply connection electrode 20 may have a shape of a strip extending along the first direction X, a first end of the power supply connection electrode 20 is connected to the first power supply line 51 through the seventh via V7, and a second end of the power supply connection electrode 20 is connected to the first region of the second active layer 22 through the second via V2, writing of the first power supply signal into the first electrode of the second transistor T2 by the first power supply line 51 is achieved.

In an exemplary implementation, first ends of the power supply connection electrodes 20 in two adjacent sub-pixels of two repetition units adjacent in the first direction X may be connected to each other. For example, first ends of the two power supply connection electrodes 20 in the second sub-pixel P2 of the first repetition unit Q1 and the first sub-pixel P1 of the second repetition unit Q2 are connected to each other. For another example, first ends of the two power supply connection electrodes 20 in the fourth sub-pixel P4 of the first repetition unit Q1 and the third sub-pixel P3 of the second repetition unit Q2 are connected to each other.

In an exemplary implementation, the power supply connection electrodes 20 in two adjacent sub-pixels of two repetition units adjacent in the first direction X are interconnected to form an integral structure.

In an exemplary implementation, first ends of the power supply connection electrodes 20 in two adjacent sub-pixels of two repetition units adjacent in the second direction Y may be connected to each other. For example, for a first repetition unit Q1 and a third repetition unit Q3 adjacent in the second direction Y, first ends of the power supply connection electrodes 20 in the third sub-pixel P3 of the first repetition unit Q1 and the first sub-pixel P1 of the third repetition unit Q3 may be connected to each other, and the first ends of the power supply connection electrodes 20 in the fourth sub-pixel P4 of the first repetition unit Q1 and the second sub-pixel P2 of the third repetition unit Q3 may be connected to each other. For another example, for a second repetition unit Q2 and a fourth repetition unit Q4 adjacent in the second direction Y, first ends of the power supply connection electrodes 20 in the third sub-pixel P3 of the second repetition unit Q2 and the first sub-pixel P1 of the fourth repetition unit Q4 may be connected to each other, and the first ends of the power supply connection electrodes 20 in the fourth sub-pixel P4 of the second repetition unit Q2 and the second sub-pixel P2 of the fourth repetition unit Q4 may be connected to each other.

In an exemplary implementation, the power supply connection electrodes 20 in two adjacent sub-pixels of two repetition units adjacent in the second direction Y are interconnected to form an integral structure.

In an exemplary implementation, the power supply connection electrodes 20 in adjacent sub-pixels of the repetition units adjacent in the first direction X and the second direction Y are interconnected to form an integral structure, i.e., the power supply connection electrodes 20 in the four adjacent sub-pixels of the adjacent repetition units are interconnected to form an integral structure. For example, the power supply connection electrode 20 in the fourth sub-pixel P4 of the first repetition unit Q1, the power supply connection electrode 20 in the third sub-pixel P3 of the second repetition unit Q2, the power supply connection electrode 20 in the second sub-pixel P2 of the third repetition unit Q3, and the power supply connection electrode 20 in the first sub-pixel P1 of the fourth repetition unit Q4 are interconnected to form an integral structure. By providing the power supply connection electrodes 20 in the four adjacent sub-pixels of the adjacent repetition unit are interconnected to form an integral structure according to the present disclosure, not only a quantity of vias can be effectively reduced, an area occupied by the pixel drive circuits can be reduced, the pixel aperture ratio can be increased, and the display resolution can be improved, but also manufacturing process can be simplified by the reduced quantity of the vias, the production cost can be reduced, and the product yield can be improved.

In an exemplary implementation, a processing process and a formed structure of a third insulation layer, a planarization layer, a fourth conductive layer, a pixel definition layer, an organic emitting layer, a cathode and an encapsulation structure layer that are to be formed subsequently are substantially the same as those of the foregoing embodiment, and which not be repeated herein.

An embodiment of the present disclosure provides a display substrate with a bottom emission structure. The power supply connection electrodes in two adjacent sub-pixels of two repetition units adjacent in the first direction X are interconnected to form an integral structure and the power supply connection electrodes in two adjacent sub-pixels of two repetition units adjacent in the second direction Y are interconnected to form an integral structure, so that a quantity of switch vias can be effectively reduced, an occupied area of the pixel drive circuit can be reduced, pixel aperture ratio can be increased, and display resolution can be improved. In addition, manufacturing process can be simplified by the reduced quantity of the switch vias, a production cost can be reduced, and a product yield can be improved.

The display substrate of an embodiment of the present disclosure also has the technical effects of reducing a quantity of patterning processes, reducing a quantity of scan signal lines, increasing pixel aperture ratio, and the like.

The structure shown in the present disclosure and the manufacturing process thereof are merely exemplary description. In an exemplary implementation, corresponding structures may be changed and patterning processes may be added or reduced according to actual needs, which is not limited here in the present disclosure.

In an exemplary implementation, the display substrate according to the present disclosure may be applied to a display apparatus with a pixel drive circuit, such as an OLED, a quantum dot display (QLED), a light emitting diode display (Micro LED or Mini LED), or a Quantum Dot Light Emitting Diode display (QDLED), etc., which is not limited here in the present disclosure.

An embodiment of the present disclosure further provides a method for manufacturing a display substrate to manufacture the aforementioned display substrate. In an exemplary implementation, the display substrate includes multiple repetition units, at least one repetition unit includes multiple sub-pixels forming at least two pixel rows and at least two pixel columns. The manufacturing method includes:
A pixel drive circuit is formed in at least one sub-pixel. The pixel drive circuit is connected to a first power supply line. The first power supply line is configured to provide a first power supply signal to the pixel drive circuit. The pixel drive circuit at least includes a drive transistor and a power supply connection electrode. The drive transistor at least includes a drive active layer. In at least one sub-pixel, a first end of the power supply connection electrode is connected to the first power supply line through a power supply via, and a second end of the power supply connection electrode is connected to a first region of the drive active layer through an active via. Two adjacent sub-pixels of two repetition units adjacent in a pixel row direction share the power supply via and two adjacent sub-pixels of two repetition units adjacent in a pixel column direction share the power supply via.

The present disclosure further provides a display apparatus which includes the display substrate according to the aforementioned embodiments. The display apparatus may be any product or component with a display function, such as a mobile phone, a tablet computer, a television, a display, a laptop computer, a digital photo frame, and a navigator.

Although implementations disclosed in the present disclosure are as above, it should be noted that the above implementations are exemplary only rather than restrictive. Therefore, the present disclosure is not limited to what is specifically shown and described herein. Various modifications, substitutions or omissions may be made in forms and details of implementation modes without departing from the scope of the present disclosure.

## Claims

1. A display substrate, comprising a plurality of repetition units, wherein at least one of the repetition units comprises a plurality of sub-pixels forming at least two pixel rows and at least two pixel columns, at least one of the sub-pixels comprises a pixel drive circuit, the pixel drive circuit is connected to a first power supply line, the first power supply line is configured to provide a first power supply signal to the pixel drive circuit; the pixel drive circuit at least comprises a drive transistor and a power supply connection electrode, the drive transistor at least comprises a drive active layer; in at least one of the sub-pixels, a first end of the power supply connection electrode is connected to the first power supply line through a power supply via, and a second end of the power supply connection electrode is connected to a first region of the drive active layer through an active via; two adjacent sub-pixels of two repetition units adjacent in a pixel row direction share the power supply via, and/or two adjacent sub-pixels of two repetition units adjacent in a pixel column direction share the power supply via.

2. The display substrate according to claim 1, wherein first regions of drive active layers of two adjacent sub-pixels of two repetition units adjacent in the pixel column direction are connected to each other.

3. The display substrate according to claim 2, wherein the drive active layers of the two adjacent sub-pixels of the two repetition units adjacent in the pixel column direction are interconnected to form an integral structure, the drive active layers of the integral structure have grooves, openings of adjacent grooves in at least one repetition unit are provided oppositely, a groove has a groove width and a groove depth, the groove width is less than the groove depth, the groove width is a dimension in the pixel column direction, and the groove depth is a dimension in the pixel row direction.

4. The display substrate according to claim 1, wherein first ends of power supply connection electrodes of two adjacent sub-pixels of two repetition units adjacent in the pixel row direction are connected to each other and two adjacent sub-pixels of two repetition units adjacent in the pixel column direction share the power supply connection electrodes.

5. The display substrate according to claim 4, wherein the power supply connection electrodes of the two adjacent sub-pixels of the two repetition units adjacent in the pixel row direction are interconnected to form an integral structure.

6. The display substrate according to claim 2, wherein the pixel drive circuit further comprises an active connection electrode, a first end of the active connection electrode is connected to the first region of the drive active layer, the power supply connection electrode is simultaneously connected to the first power supply line and a second end of the active connection electrode through a switch via, the switch via comprises a shallow half hole and a deep half hole, the shallow half hole is an active via exposing the second end of the active connection electrode, and the deep half hole is a power supply via exposing the first power supply line.

7. The display substrate according to claim 6, wherein the active connection electrode and the drive active layer are interconnected to form an integral structure.

8. The display substrate according to claim 6, wherein two adjacent sub-pixels of two repetition units adjacent in the pixel row direction share a switch via and two adjacent sub-pixels of two repetition units adjacent in the pixel column direction share a switch via.

9. The display substrate according to claim 6, wherein adjacent sub-pixels of repetition units adjacent in the pixel row direction and the pixel column direction share the switch via.

10. The display substrate according to claim 6, wherein second ends of active connection electrodes of two adjacent sub-pixels of two repetition units adjacent in the pixel row direction are connected to each other and two adjacent sub-pixels of two repetition units adjacent in the pixel column direction share the active connection electrodes.

11. The display substrate according to claim 10, wherein the active connection electrodes of the two adjacent sub-pixels of the two repetition units adjacent in the pixel row direction are interconnected to form an integral structure.

12. The display substrate according to claim 6, wherein first regions of second active layers in adjacent sub-pixels of repetition units adjacent in the pixel row direction and the pixel column direction are connected to each other through the active connection electrode.

13. The display substrate according to claim 6, wherein adjacent sub-pixels of repetition units adjacent in the pixel row direction and the pixel column direction share the power supply connection electrode.

14. The display substrate according to claim 1, wherein power supply connection electrodes of two adjacent sub-pixels of two repetition units adjacent in the pixel row direction are interconnected to form an integral structure and power supply connection electrodes of two adjacent sub-pixels of two repetition units adjacent in the pixel column direction are interconnected to form an integral structure.

15. The display substrate according to any one of claims 1 to 14, wherein at least one of the repetition units comprises two first power supply lines, four data signal lines and one compensation signal line, the compensation signal line is between adjacent pixel columns, the two first power supply lines are on two sides of a repetition unit in the pixel row direction, the first one of the first power supply lines, the first data signal line, the second data signal line, the compensation signal line, the third data signal line, the fourth data signal line and the second one of the first power supply lines are sequentially provided along the pixel row direction, and the drive transistor is provided between the second data signal line and the compensation signal line or between the compensation signal line and the third data signal line.

16. The display substrate according to any one of claims 1 to 14, wherein in at least one sub-pixel, the pixel drive circuit further comprises a first connection electrode, a second connection electrode, and a storage capacitor, the storage capacitor at least comprises a first plate, the first connection electrode and the second connection electrode are provided on two sides of the first plate in the pixel column direction, and are respectively connected to the first plate; in at least one sub-pixel, a width of the first connection electrode is less than a width of the second connection electrode, and a width is a dimension in the pixel row direction.

17. The display substrate according to any one of claims 1 to 14, wherein in a direction perpendicular to the display substrate, the display substrate comprises a second conductive layer, a semiconductor layer, and a third conductive layer that are sequentially provided on a base substrate, the first power supply line is provided in the second conductive layer, the drive active layer is provided in the semiconductor layer, and the power supply connection electrode is provided in the third conductive layer.

18. The display substrate according to any one of claims 1 to 14, wherein widths of drive active layers in adjacent sub-pixels in the pixel row direction are different, widths of drive active layers in adjacent sub-pixels in the pixel column direction are different, and a width is a minimum dimension of a drive active layer in the pixel column direction.

19. The display substrate according to claim 18, wherein in the pixel row direction, a first sub-pixel and a second sub-pixel are alternately provided, a width of a drive active layer in the first sub-pixel is greater than a width of a drive active layer in the second sub-pixel; or, in the pixel row direction, a third sub-pixel and a fourth sub-pixel are alternately provided, a width of a drive active layer in the third sub-pixel is less than a width of a drive active layer in the fourth sub-pixel.

20. The display substrate according to claim 18, wherein in the pixel column direction, a first sub-pixel and a third sub-pixel are alternately provided, a width of a drive active layer in the first sub-pixel is greater than a width of a drive active layer in the third sub-pixel; or, in the pixel column direction, a second sub-pixel and a fourth sub-pixel are alternately provided, a width of a drive active layer in the second sub-pixel is less than a width of a drive active layer in the fourth sub-pixel.

21. A display apparatus, comprising the display substrate according to any one of claims 1 to 20.

22. A method for manufacturing a display substrate, wherein the display substrate comprises a plurality of repetition units, at least one of the repetition units comprises a plurality of sub-pixels forming at least two pixel rows and at least two pixel columns; the manufacturing method comprises:
forming a pixel drive circuit in at least one sub-pixel, wherein the pixel drive circuit is connected to a first power supply line, the first power supply line is configured to provide a first power signal to the pixel drive circuit; the pixel drive circuit at least comprises a drive transistor and a power supply connection electrode, the drive transistor at least comprises a drive active layer; in at least one sub-pixel, a first end of the power supply connection electrode is connected to the first power supply line through a power supply via, and a second end of the power supply connection electrode is connected to a first region of the drive active layer through an active via; two adjacent sub-pixels of two repetition units adjacent in a pixel row direction share a power supply via and two adjacent sub-pixels of two repetition units adjacent in a pixel column direction share a power supply via.
